# EUROPEAN PATENT SPECIFICATION

(11) **EP 2 539 939 B1**
(45) Date of publication and mention of the grant of the patent: **21.05.2014**
(21) Application number: 11707500.2
(22) Date of filing: 25.02.2011
(51) Int. Cl.: H01L 31/068, H01L 31/0224, H01L 31/18

(54) **METHOD OF FABRICATION OF A BACK-CONTACTED PHOTOVOLTAIC CELL, AND BACK-CONTACTED PHOTOVOLTAIC CELL MADE BY SUCH A METHOD**
VERFAHREN ZUR HERSTELLUNG EINER PHOTOVOLTAISCHEN ZELLE MIT RÜCKSEITIGEM KONTAKT UND AUF DIESE WEISE HERGESTELLTE PHOTOVOLTAISCHE ZELLE MIT RÜCKSEITIGEM KONTAKT
PROCÉDÉ DE FABRICATION D'UNE CELLULE PHOTOVOLTAÏQUE À CONTACT À L'ARRIÈRE, AINSI QUE CELLULE PHOTOVOLTAÏQUE À CONTACT À L'ARRIÈRE FABRIQUÉE PAR CE PROCÉDÉ

(30) Priority: 26.02.2010 NL 2004310
(43) Date of publication of application: 02.01.2013
(73) Proprietor: Stichting Energieonderzoek Centrum Nederland, 1755 LE Petten (NL)
(72) Inventor: GUILLEVIN, Nicolas, NL-1815 GP Alkmaar (NL); GEERLIGS, Lambert ,Johan, NL-1755 LE Petten (NL)
(74) Representative: Nederlandsch Octrooibureau
(86) International application number: PCT/NL2011/050137
(87) International publication number: WO 2011/105907

(56) References cited:
- EP-A2- 1 950 810
- WO-A1-2009/063754
- US-A1- 2007 023 082
- US-A1- 2009 211 628
- FILIP GRANEK ET AL: "A Systematic Approach to Reduce Process-Induced Shunts in Back-Contacted MC-Si Solar Cells", PHOTOVOLTAIC ENERGY CONVERSION, CONFERENCE RECORD OF THE 2006 IEEE 4TH WORLD CONFERENCE ON, IEEE, PI, 1 May 2006 (2006-05-01), pages 1319-1322, XP031007558, ISBN: 978-1-4244-0016-4
- HARDER N-P ET AL: "Laser-processed high-efficiency silicon RISE-EWT solar cells and characterisation", PHYSICA STATUS SOLIDI (C), WILEY - VCH VERLAG, BERLIN, DE, vol. 6, no. 3, 14 January 2009 (2009-01-14), pages 736-743, XP002588333, ISSN: 1610-1634, DOI: DOI:10.1002/PSSC.200880720
- VAN KERSCHAVER E ET AL: "Back-contact solar cells: a review", PROGRESS IN PHOTOVOLTAICS. RESEARCH AND APPLICATIONS, JOHN WILEY AND SONS, CHICHESTER, GB, vol. 14, no. 2, 1 March 2006 (2006-03-01), pages 107-123, XP002577679, ISSN: 1062-7995, DOI: DOI:10.1002/PIP.657 [retrieved on 2005-12-20]

## Description

### Field

The present invention relates to a method of fabrication of a back-contacted photovoltaic cell. Moreover, the present invention relates to a back-contacted photovoltaic cell.

### Prior art

A back-contacted photovoltaic cell or solar cell, based on either a monocrystalline or polycrystalline silicon wafer, comprises a metallization scheme in which contacting electrodes of positive and negative polarity are each arranged on a back side of the solar cell. Such a metallization scheme applies either metallization wrap through (MWT) or emitter wrap through (EWT) or an interdigitated back contact solar cell (IBC) concept to bring the contacting electrodes to the back side so as to have a maximal area available for photovoltaic conversion on a front side of the solar cell that in use faces a radiation source (e.g., the sun). The top layer of the MWT solar cell and usually also of the EWT solar cell connects to a front side contacting electrode on the backside of the cell by means of one or more metal plugs in holes that extend through the wafer. The arrangement of a metal plug or a metal body in a hole through the substrate is also known as a "via", the hole is also referred to as a "via hole".

The back-contacted solar cell of the prior art suffers from a relatively poor efficiency for a number of reasons.

It is known that in conventional MWT or EWT technology the conductance through the vias can be relatively small. The metallization of the vias is typically obtained by means of a screen printing process which presses metal paste into the vias. To obtain vias completely filled with metal by this method is difficult. As a result of the low conductance the efficiency of the solar cell is therefore reduced.

In conventional EWT the conductance through the shallow diffused surface layer of the vias is small and limits the efficiency of the solar cell. It can be increased only with additional complexity and cost for the solar cell process. Example solutions in literature disclose the use of additional diffusion in the via, heavier than on the front surface of the wafer, or the use of internally metalizing the via by plating. The latter can give rise to problems of shunt. In the state of the art, it is not well possible to sufficiently fill all vias with heavily doped surface without special or additional process steps or danger of shunts.

Additionally, in conventional EWT or MWT the via is internally diffused similar or simultaneously to the front surface of the wafer. The front surface of the wafer is then coated with anti-reflection coating, the inside of the via is not coated or not completely, or not with the same thickness. Therefore the metallisation of the via can more easily create shunts in the via than on the surface of the wafer. Avoiding this requires special processing, for example a separate diffusion step for the inside surface of the via.

Moreover, in conventional EWT or MWT both n-type and p-type doped surface areas have to be created on the rear of the cell to provide contact to base and emitter. For isolation between the two, and passivation where the p-n-junction reaches the surface of the wafer, special process steps are required such as local application of diffusion barrier materials.

WO5076960 discloses that on a substrate via holes are created prior to the creation of front and rear side doped areas. From WO5076960 it is additionally known to improve the conductance within a via hole by doping the via walls using a diffusion process preceding the screen printing process. The diffusion process must be arranged to obtain a via wall with higher dopant concentration than the optimum (low) dopant concentration of the front side layer of the solar cell. Such diffusion process for the via hole is complex since it requires additional production steps, which may also adversely interfere with the formation of the front side layer. In particular, a relatively high dopant concentration at the front side layer of the wafer due to the doping of the via walls may enhance the recombination of minority charge carriers in the front side layer.

Also, it is known to use electroplating for metallization of the vias in the wafer. However, this technology is relatively costly compared to screen printing.

The publications "A systematic approach to reduce process-induced shunts in back-contacted MC-Si solar cells" by F. Granek et al, Photovoltaic energy conversion, the 2006 IEEE 4th world conference, IEEE, (2006-05-01), pp. 1319-1322, and more elaborately, "Processing and comprehensive characterization of screen-printed mc-Si metal wrap through (MWT) solar cells "by F. Clement et al, 22nd European Photovoltaic Solar Energy Conference, 3-7 September 2007, Milan, Italy, pp. 1399-1402, disclose that in conventional MWT technology the geometry of a back surface field (BSF) is defined by screen printing of an aluminium paste. It is straightforward to omit the BSF in an area around each via, by a suitable screen design. The emitter contact is printed on the via. Since the BSF is absent around the via, the emitter contact does not contact the BSF or BSF metallization. When using an emitter diffusion process prior to the printing of the aluminium layer, the emitter is present in the via and on the rear surface around each via (where the BSF is absent). Isolation between emitter and base of the solar cell is realized by a laser groove in the emitter-diffused area on the rear around each via, after creation of the emitter, where the groove is located between the emitter contact that is printed on the via, and the BSF contact that is present on the BSF. Thereby the groove creates an interruption of the emitter.

WO 2009/063754 describes a variation of the conventional MWT technology. The isolation between emitter and base is still realized by a laser groove in the emitter-diffused area around the via and around the emitter contact printed on the via, after creation of the emitter which is possible because the BSF has been created in a geometry omitting the area around the via. In addition, a dielectric layer is provided on top of the BSF and BSF contact metallization, so that the emitter contact can be printed in a geometry overlapping with the BSF and BSF contact.

In the publication "Laser-processed high-efficiency silicon RISE-EWT solar cells and characterisation" by Harder et al., Physica Staus Solidi (C), Wiley - VCH Verlag, Berlin, DE, vol. 6, no. 3, 14 January 2009, pages 736-743, the recesses in the rear surface and the through-hole vias are formed before local formation of the BSF areas by Al diffusion during an LFC process step. The BSF areas are formed at a distance from the recesses and through-holes and the steep flanks of the recesses are used for a very efficient and reliable contact separation. A similar process is also disclosed in US 2009/211628.

### Summary of the invention

It is an object of the present invention to remove or at least reduce existing disadvantages of the prior art as described above.

This object is achieved by a method for manufacturing a solar cell comprising providing a silicon semiconductor substrate of a first conductivity type, the substrate having a front and a rear surface;
the method comprising:
- creating on the rear surface a doped layer of the first conductivity type in the silicon semiconductor substrate, as rear surface doped layer for functioning as back surface field layer in the solar cell;
- creating on the front surface a doped layer of a second conductivity type as front surface doped layer for functioning as an emitter layer in the solar cell, the second conductivity type being opposite to the first conductivity type;
   wherein the method further comprises:
   creating recesses in the rear surface by removal of the rear surface doped layer in the silicon semiconductor substrate at the location of the recesses to pattern the rear surface doped field layer of the first conductivity type so as to create back surface field areas, the recesses being void of rear surface doped layer material and the recesses having a depth at least equal to or larger than the thickness of the rear surface doped layer and creating via holes in the substrate, each via hole being positioned within an associated recess.

According to an aspect, there is provided a method as described above wherein the via holes are created by one process selected from a group comprising laser drilling, water jet-guided laser drilling, laser chemical processing, suspended abrasive water jet hole drilling.

According to an aspect, there is provided a method as described above, wherein the rear surface doped layer is created by a pre-diffusion process.

According to an aspect, there is provided a method as described above, wherein the rear surface doped layer is created by a pre-diffusion process, and during formation of the front surface doped area is co-diffused to form the back surface field layer.

According to an aspect, there is provided a method as described above, wherein the creation of the recesses is done by one process selected from a group comprising laser ablation, water jet-guided laser ablation, laser chemical processing, suspended abrasive water jet ablation, and lithography.

According to an aspect, there is provided a method as described above, wherein the recesses in the rear surface are created in the rear surface doped layer after the creation of the front surface doped layer on the front surface and the rear surface doped layer on the rear surface, and
the via holes in the substrate are created after the creation of the front surface doped layer on the front surface and the rear surface doped layer on the rear surface.

According to an aspect, there is provided a method as described above, comprising - depositing an anti reflection coating layer on at least the front surface after the creation of the front surface doped area on the front surface, wherein the recesses in the rear surface are created in the rear surface doped layer after the deposition of the anti reflection coating layer, and
the via holes in the substrate are created after the deposition of the anti reflection coating layer.

According to an aspect, there is provided a method as described above, wherein the via holes in the substrate are created preceding the creation of the rear surface doped layer, and
the recesses in the rear surface are created in the rear surface doped layer after the creation of the front surface doped layer.

According to an aspect, there is provided a method as described above, wherein the via holes in the substrate are created preceding the creation of the rear surface doped layer, and
the recesses in the rear surface are created before the creation of the front surface doped layer.

According to an aspect, there is provided a method as described above, wherein the via holes in the substrate are created after the creation of the rear surface doped layer but preceding the creation of the front surface doped layer, and
the recesses in the rear surface are created in the rear surface doped layer after the creation of the front surface doped layer.

According to an aspect, there is provided a method as described above, wherein the recesses in the rear surface are created in the rear surface doped layer but preceding the creation of the front surface doped layer, and
the via holes in the substrate are created after the creation of the front surface doped layer.

According to an aspect, there is provided a method as described above, wherein the recesses in the rear surface are created in the rear surface doped layer but preceding the creation of the front surface doped layer, and
the via holes in the substrate are created after creation of the rear surface doped layer but preceding the creation of the front surface doped layer.

According to an aspect, there is provided a method as described above, further comprising:
metal printing and firing for forming metallization patterns in accordance with the design of the solar cell and forming metal plugs in the via holes, the solar cell being of either EWT type or MWT type.

According to an aspect, there is provided a method as described above, wherein the creation of the via holes in the substrate by the laser hole drilling process is followed by:
- etching the substrate to remove damaged substrate material.

According to an aspect, there is provided a method as described above, wherein the creation of the recesses in the rear surface is followed by:
- etching the substrate to remove damaged substrate material and possible dopant residues.

According to an aspect, there is provided a method as described above, wherein the creation of the via holes, is preceded by deposition of an etching protection barrier on either the rear or the front or the front and rear surface.

According to an aspect, there is provided a method as described above, wherein the creation of the recesses is preceded by deposition of an etching protection barrier on either the rear or the front and rear surface.

According to an aspect, there is provided a method as described above, wherein the deposition of an etching protection barrier on the rear side precedes the creation of the front side doped layer.

According to an aspect, there is provided a method as described above, wherein the deposition of an etching protection barrier on the rear side follows the creation of the front side doped layer.

According to an aspect, there is provided a method as described above, wherein the etching protection barrier on the front surface is a dopant diffusion glass layer.

According to an aspect, there is provided a method as described above, wherein the etching protection barrier on the rear surface is created by a thermal oxidation process.

According to an aspect, there is provided a method as described above, wherein the etching protection barrier on the rear surface is an etching protection barrier selected from a group comprising silicon nitride, silicon oxide, aluminium oxide, a dielectric, a stack of dielectric layers, and a resist material.

According to an aspect, there is provided a method as described above, wherein the etching protection barrier on the front surface is an etching protection barrier selected from a group comprising silicon nitride, silicon oxide, aluminium oxide, a dielectric, a stack of dielectric layers, and a resist material.

According to an aspect, there is provided a method as described above, wherein the creation of the via holes is combined with the creation of vias by a thermomigration process.

Also, the present invention relates to a back-contacted solar cell manufactured by a method as described above; the solar cell comprising:
a silicon semiconductor substrate having a front and a rear surface;
   - having on the rear surface a doped layer of the first conductivity type in the silicon semi substrate, as rear surface doped layer for functioning as back surface field layer in the solar cell;
   - having on the front surface a doped layer of a second conductivity type as front surface doped layer for functioning as an emitter layer in the solar cell, the second conductivity type being opposite to the first conductivity type;
wherein:
   the rear surface comprises recesses that pattern the back surface field layer of the first conductivity type in back surface field areas, the recesses being void of back surface field layer material
   the substrate comprises via holes between the front and rear surfaces, the via holes being located within the recesses.

According to an aspect, there is provided a back-contacted solar cell as described above, wherein the solar cell comprises an anti reflection coating layer on a passivation layer on at least the front surface.

According to an aspect, there is provided a back-contacted solar cell as described above, where a depth of the recess is at least equal to or larger than the thickness of the rear surface doped layer.

According to an aspect, there is provided a back-contacted solar as described above, further comprising:
a passivation layer on walls of the via holes, and
an anti-reflection coating layer covering the passivation layer on the walls of the via hole.

According to an aspect, there is provided a back-contacted solar cell as described above, further comprising:
an emitter layer on walls of each via hole, and
the emitter layer on the walls of the via holes being covered by a passivation layer;
the passivation layer being covered by an anti reflection coating layer.

According to an aspect, there is provided a back-contacted solar cell as described above, wherein the back surface field areas are covered by an etching protection barrier layer and the recessed areas are not covered by the etching protection barrier layer.

Advantageous embodiments are further defined by the dependent claims.

### Brief description of drawings

The invention will be explained in more detail below with reference to a few drawings in which illustrative embodiments of the invention are shown.
Figure 1 shows a flow diagram of a first process for manufacturing a back-contacted photovoltaic cell in accordance with the present invention;
Figure 2 shows a cross-section of a first back-contacted photovoltaic cell manufactured according to a process of the present invention;
Figure 3 shows a flow diagram of a second process for manufacturing a back-contacted photovoltaic cell in accordance with the present invention;
Figure 4 shows a cross-section of a second back-contacted photovoltaic cell manufactured according to a process of the present invention;
Figure 5a shows a flow diagram of a third process for manufacturing a back-contacted photovoltaic cell in accordance with the present invention;
Figure 5b shows a cross-section of a back-contacted photovoltaic cell manufactured according to the third process;
Figure 6 shows a flow diagram of a fourth process for manufacturing a back-contacted photovoltaic cell in accordance with the present invention;
Figure 7 shows a cross-section of a third back-contacted photovoltaic cell manufactured to a process of the present invention;
Figure 8a shows a flow diagram of a fifth process for manufacturing a back-contacted photovoltaic cell in accordance with the present invention, and
Figure 8b shows a cross-section of a back-contacted photovoltaic cell manufactured according to the fifth process;
Figure 9 shows a cross-section of a further back-contacted photovoltaic cell manufactured according to a process of the present invention;
Figure 10 shows a cross-section of a yet another back-contacted photovoltaic cell manufactured according to a process of the present invention;
Figures 11A, 11B show a cross-section of back-contacted photovoltaic solar cells according to an embodiment of the invention.

### Detailed description

According to the prior art, a back-contacted solar cell can be manufactured by a sequence of process steps.

A solar cell is manufactured from a semiconductor wafer, more in particular a wafer of silicon, either polycrystalline or monocrystalline.

The silicon wafer has two main surfaces, a front surface and a rear surface. The front surface is to be arranged as a solar cell surface for capturing radiation from e.g. the sun and converting it into electric energy. In a back-contacted solar cell, the rear surface is arranged to accommodate the electrodes of both positive and negative polarity. In case of the MWT concept, a front surface metal grid is present on the front surface.

Below a short description of the basic process steps is given. For further reference each basic step is indicated by a reference character. The basic process sequence comprises a texturing step [A] in which the front surface obtains a texture, which reduces the reflectivity of the front surface and improves the absorption of radiation.

After texturing, in a so called pre-diffusion process [B] a first pre-doped area is created on the rear surface of the substrate which will function as back surface field BSF. During the pre-diffusion process [B] a first dopant source layer is deposited on the rear surface. The first dopant source layer contains a dopant element for doping the first pre-doped area or BSF. For example for n-type dopant such as phosphor, the first dopant source layer may be a phosphor silicate layer (also known as PSG, phosphor silicate glass).

During or after deposition of the first dopant source layer the silicon wafer is annealed to allow the first dopant element to diffuse (to some extent) into the rear surface of the silicon wafer to form a first diffused (BSF) layer. It is known from the prior art to block the front surface in some manner to avoid deposition of the first dopant source layer on the front surface. For example, the silicon wafer is placed in a front-to-front configuration with another silicon wafer to cover the respective front surfaces of both wafers.

Next, a removal process [C] to remove the first dopant source layer is carried out. Usually, also a spill-over of the first dopant source layer on the front surface is removed as well during this removal process. Typically, the first dopant source layer is a glass or silicate layer, the removal process is then denoted as a glass removal process.

Then, a single sided etch [D] is carried out on the front surface to remove any parasitic BSF layer from the front surface of the silicon wafer.

Subsequently, an emitter diffusion process [E] is carried out to create an emitter area on the front surface of the silicon wafer. Typically, for the manufacture of a back contacted solar cell with n-type BSF, the emitter area will have p-type conductivity. To obtain p-type conductivity, a second dopant source layer of p-type conductivity which contains a second dopant source element is deposited on the front surface. For example, the second dopant element is boron and the second dopant source layer is a boron silicate layer (or boron silicate glass BSG layer). During or after the deposition of the p-type second dopant source layer, the silicon wafer is annealed to allow the second dopant element to diffuse (to some extent) into the front surface of the silicon wafer to form the second diffused layer, i.e., the emitter area. Usually, during the anneal to create the emitter area, the first dopant element in the first diffused layer on the rear surface of the silicon wafer diffuses further so as to extend the thickness of the first diffused layer (also referred to as co-diffusion of the BSF area in combination with diffusion of the emitter area).

Next, the silicon wafer is exposed to an edge isolation process [F]. The edge isolation process comprises a plasma etching process which etches the edge of the silicon wafer to remove any conductive material on the edge and to overcome electric leakage between front and rear surface across the edge. Alternative edge isolation processes comprise e.g., laser assisted isolation and grinding. Edge isolation processes can be performed at various positions in the process flow but always after BSF and emitter formation.

Typically, according to the prior art, a laser drilling process is carried out to form via holes between the front and rear surfaces of the silicon wafer. This laser drilling step may be followed by a diffusion process to improve the conductance of the via by a diffusion process to dope the via walls with suitable p-type or n-type dopant elements.

After the via hole creation and optional doping of the via walls, a second glass removal process [G], i.e., an etching process, is carried out to remove any silicate layer that is present on front and rear surface of the silicon wafer and in the vias.

Subsequently, the silicon wafer is provided with a passivation layer (typically on both front and rear surface) by deposition or growth of a passivation layer [H]. For example, deposition is done by means of a wet chemical oxidation process.

Further, a deposition process [J] for an anti reflection coating (ARC) layer is carried out to create an ARC layer on the front surface and typically also a coating on the rear surface of the silicon wafer. Formation of such ARC and rear coating layer may comprise a deposition of a silicon nitride layer. On the front surface, such a coating can enhance the surface passivation as well as reduce reflection of light from the silicon wafer. On the rear surface, such a coating can enhance the surface passivation as well as enhance rear side reflection of light back into the silicon wafer, or in case of so-called bi-facial solar cells it can enhance the surface passivation as well as reduce reflection of light incident on the rear of the silicon wafer. Henceforth in the text, this deposition process [J] or [J'] is briefly described as to create an ARC on front or both surfaces, and the coating layer on the rear is also described as an ARC layer even though its function may not be primarily or not at all to reduce reflection.

Finally, rear and front side metal printing and firing [K] is done to form the metallization patterns in accordance with the design of the solar cell. Specifically for back contact solar cells it is noted that additionally, the metal plugs in the via holes are formed at this stage [K].

The present invention recognizes that the above prior art process scheme has a difficulty to obtain cells without shunting due to parasitic diffusion problem through the vias.

The prior art results in a geometry where the front contact (plug) metallization is deposited on the rear BSF, with only a thin dielectric isolation layer in-between. This is an additional cause for shunting in the solar cell because the front metal contact that is contacting the emitter of the solar cell, is very near to the highly doped BSF which is electrically connected to the base of the solar cell. WO 2009/063754 provides a dielectric film as isolation layer between a p+ layer on the back surface and the front contact (plug) metallization to reduce this shunt. However, contrary to this prior art, it is observed here that using a normal SiNx dielectric film is not sufficient for good isolation. Providing locally an additional dielectric film which provides better isolation is a complex and costly process.

To overcome this difficulty, the present invention provides the insight that the formation of the via holes in combination with a formation of a recess in the back surface field layer at the location of the via holes removes the possibility that shunting through the vias occurs. So this means: the recess formation is done after the BSF formation.

Thus, the isolation between the front contact plug (paste) and the base of the solar cell will be significantly improved because the contact resistance of a metal to the silicon surface with normal base doping (normally less than 5×10¹⁶ cm⁻³) is much higher than the contact resistance of metal to highly-doped silicon surface as is the case for the BSF (normally more than 5×10¹⁷ cm⁻³ surface concentration, often even more than 1×10¹⁹ cm⁻³ surface dopant concentration).

Basically, the method comprises the following processes: texturing (front/rear/both); creating doped layers in front and rear surface; creating a passivation/anti-reflective coating (ARC) layer on either front or front and rear; metallization of the cell contact areas; formation of via holes by laser drilling, and recesses at the location of the via holes.

The recesses formation on the rear surface may be done by laser ablation or other laser-assisted method, or alternatively by other lithographic processes described in the literature, such as, for example, applying an etching material by screen or stencil printing or similar techniques, or by inkjet or other jetting techniques, or applying an etching mask by screen or stencil printing or similar techniques, or inkjet or other jetting techniques followed by wet chemical or plasma etching process, or by photolithography followed by wet chemical or plasma etching, or depositing a protection barrier through a mechanical mask followed by wet chemical or plasma etching.

According to the invention, the method can be embodied by the following generalized sequences, while omitting optional process steps. The optional process steps may have benefits such as for cell efficiency. Note that below, the sequences will be described in more detail with reference to the drawings of this application.

A first sequence according to the present invention is by a process flow which is generally illustrated by:
p1) texturing (front/rear/both surfaces);
p2) creating doped layers in front and rear surface;
p3) formation of via holes and recesses at the location of the via holes;
p4) creating a passivation/anti-reflective coating (ARC) layer and
p5) metallization of the cell contact areas.

As an option, the flow may comprise p3a) Deposition of front- and/or rear surface protection barrier(s), after p2) creating doped layers in front and rear surface or in between the creation of the rear and front doped layers.

As a further option after formation of via holes and recesses, the first sequence may comprise an etching to remove damage and/or to remove the rear surface doped layer.

A second sequence according to the present invention is by a process flow which is generally illustrated by:
q1) texturing (front/rear/both surfaces);
q2) creating doped layers in front and rear surface;
q3) creating a passivation/anti-reflective coating (ARC) layer;
q4) formation of via holes and recesses at the location of the via holes;
q5) metallization of the cell contact areas.

As an option, the second sequence may comprise an etching to remove damage and/or to remove the rear surface doped layer.

A third sequence according to the present invention is by a process flow which is generally illustrated by
r1) texturing (front/rear/both surfaces);
r2) creating doped layers in front and rear surface;
r3) formation of recesses at the location of the via holes between the creation of the front surface doped layer and the creation of the rear surface doped layer;
r4) formation of via holes after the creation of the doped layers in front and rear surfaces;
r5) creating a passivation/anti-reflective coating (ARC) layer and
r6) metallization of the cell contact areas.

As an option, the flow may comprise r2a) Deposition of front- and/or rear surface protection barrier(s), in between the creation of the front and rear doped layers.

As a further option, the process flow may comprise after formation of via holes and recesses an etching to remove damage and/or to remove the rear surface doped layer.

As an option, the flow may comprise formation of via holes after the creation of the rear surface doped layer but before the creation of the front surface doped layer.

A fourth sequence according to the present invention is by a process flow which is generally illustrated by
s1) texturing (front/rear/both surfaces);
s2) creating doped layers in front and rear surface;
s3) formation of via holes between the creation of the front surface doped layer and the creation of the rear surface doped layer;
s4) formation of recesses at the location of the via holes after the creation of the doped layer in front and rear surface;
s5) creating a passivation/anti-reflective coating (ARC) layer and
s6) metallization of the cell contact areas.

As an option, the flow may comprise s2a) Deposition of front- and/or rear surface protection barrier(s), in between the creation of the front and rear doped layers.

As a further option, the process flow may comprise after formation of via holes and recesses an etching to remove damage and/or to remove the rear surface doped layer.

A fifth sequence according to the present invention is by a process flow which is generally illustrated by
t1) formation of via holes;
t2) texturing (front/rear/both surfaces);
t3) creating doped layers in front and rear surface;
t4) formation of recesses at the location of the via holes after the creation of the doped layer in front and rear surface;
t5) creating a passivation/anti-reflective coating (ARC) layer and
t6) metallization of the cell contact areas.

As an option, the flow may comprise t3a) Deposition of front- and/or rear surface protection barrier(s),after or in between the creation of the front and rear doped layers.

As a further option, the process flow may comprise after formation of via holes and recesses an etching to remove damage and/or to remove the rear surface doped layer.

It is noted that creation of a passivation/ARC layer may be omitted if a layer that was deposited earlier performs the function of passivation/ARC.

The deposition of the protection barrier(s) serves to protect an existing diffusion layer from subsequent etching. It is optional because the recess or drilling formation may or may not induce damage and may or may not leave behind a doped layer. It is also optional because the etching material may be applied in a pattern, only where it is required. The protection barrier can be sacrificial (i.e., it will be removed later in the production process) or non-sacrificial (i.e., it will remain on the solar cell). The protection barrier(s) may comprise e.g., silicon dioxide SiO2, silicon nitride SiNx, resist-like materials as known from lithographical processes for microelectronic devices, etc.

The etching step to remove damage serves to remove any laser-induced damage due to the recess and/or drilling and to remove any rear surface doped layer. It is optional because the laser recess or via formation may or may not induce damage and may or may not leave behind a doped layer. Etching may be done by using for example as etchants, alkaline based solutions such as KOH, NaOH etc, or other acid like based solutions, as depending on the nature of the barrier. Etching may also be done by a printable etching paste. The depth of the recess and etching processes combined should at least exceed the depth of the rear surface diffused layer.

The formation of recesses serves to remove locally the protection barrier(s) if present and/or the rear surface doped layer. The depth of the recess and the etching processes combined should at least exceed the depth of the rear surface diffused layer. The recesses formation on the rear surface may be done by laser ablation or other laser-assisted method. Alternatively the recesses can be created by other lithographic processes, such as, for example, applying an etching material in a pattern by screen or stencil printing or similar techniques, or by inkjet or other jetting techniques, or applying an etching mask in a pattern by screen or stencil printing or similar techniques, or inkjet or other jetting techniques followed by wet chemical or plasma etching process, or by photolithography followed by wet chemical or plasma etching, etc.

It is noted that typically each via hole is positioned within an associated recess area. In that manner the via (connecting to the emitter) is electrically isolated from adjacent BSF areas.

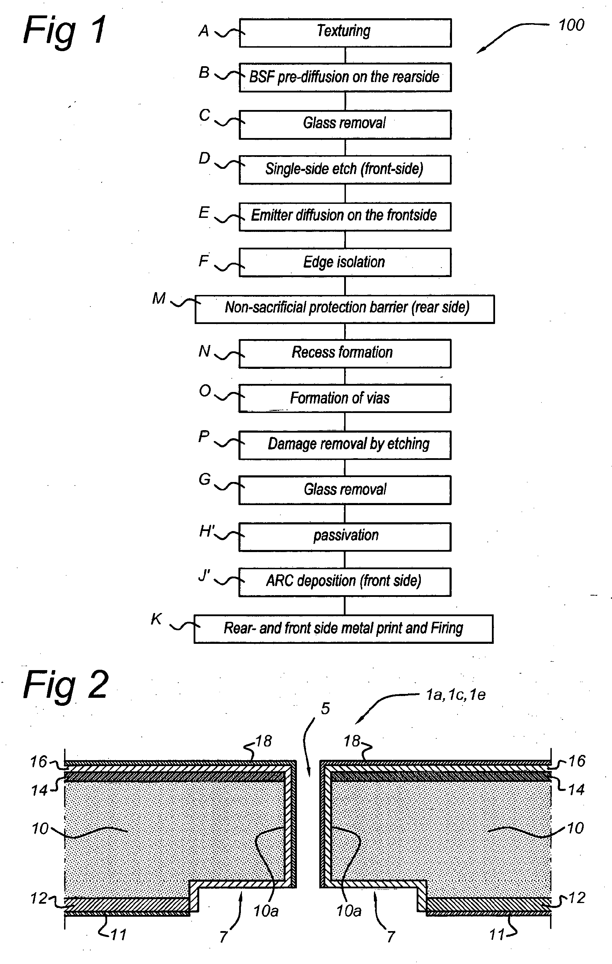

Figure 1 shows a flow diagram of a first process 100 for manufacturing a back-contacted solar cell in accordance with the present invention.

The structure of the solar cell being manufactured by this first process 100 will be illustrated with reference to figure 2.

According to the first process, a back-contacted solar cell is manufactured as follows.

A silicon semiconductor wafer of a first conductivity type is provided as substrate.

First, a texturing process [A] is carried out to create at least a textured front surface of the silicon wafer. (The skilled person will appreciate that optionally the texturing process may create a textured rear surface, depending on the specific processing method. This is, however, not relevant for the present inventive concept.)

Next, a pre-diffusion process [B] is carried out on the rear surface to create a first pre-doped area, also of the first conductivity type, which will function as back surface field BSF. Typically, this process is carried out in a front-to-front configuration of the silicon wafer in combination with another silicon wafer.

Then, a glass removal process [C] is carried out to remove any glass or silicate layer that was used as dopant source layer in the pre-diffusion process [B].

In a next step, a single side etch [D] is carried out to etch the front surface so as to remove any parasitic BSF area from the front surface.

Next, the step to create the emitter area is carried out [E], while at the same time the pre-doped area on the rear surface (i.e., the BSF layer) may be further annealed with a further diffusion (i.e., co-diffused). The emitter area is arranged to have a second conductivity type, opposite to the first conductivity type.

The formation process continues by the step [F] to isolate the wafer edge.

According to an embodiment of the present invention, a subsequent step comprises a barrier layer deposition process [M] for depositing a barrier layer on the rear surface. The barrier layer is arranged to protect against a later process of etching of silicon. In an embodiment, the barrier layer is a non-sacrificial layer containing for example silicon nitride and/or aluminum oxide and/or silicon oxide and/or a stack layer. If the barrier layer is deposited before the emitter diffusion [E] it can also be arranged to protect the BSF area from subsequent emitter dopant diffusion.

In a further step, a laser ablation process [N] is carried out to create recesses in the rear surface BSF layer to pattern the BSF layer. The recesses are arranged in such a way that is beneficial for fill factor and convenient for cell metallization pattern and cell interconnection. Each recess is created so as to remove the BSF layer in the area of the recess. In that manner the recess area is electrically isolated from adjacent BSF areas.

Subsequently, a laser drilling process [O] is carried out to create the via holes.

It is noted that typically each via hole is positioned within an associated recess area. In that manner the via (connecting to the emitter) is electrically isolated from adjacent BSF areas.

The laser ablation process and the laser drilling process may be carried out as separate successive processes. Alternatively, the laser ablation process and laser drilling process may be carried out in alternation for each individual recess area and its associated via hole.

In yet a further step, an etching process for laser damage removal [P] is carried out. Additionally, the etching process may also remove dopant residues. Typically this process [P] comprises the use of an etchant that is arranged for silicon etching. For example, such an etchant comprises a solution of potassium hydroxide (KOH). Due to the use of the barrier layer (process [M]) on the rear surface, the rear surface is protected against any etching during the laser damage removal step. The front side in this case can typically be protected by the glass layer formed during the creation of the front side doped layer. Alternatively, the front side surface can be protected by a layer of silicon dioxide, silicon nitride or aluminum oxide, a resist layer, etc., deposited in a separate process step.

Next, a glass removal step [G] is carried out to remove any glass or silicate layer from front and rear surfaces.

Then, a passivation layer or stack of layers is deposited [H'] on the front surface, on typically also on the rear side ablated area as well as on the via holes.

Further, an ARC layer is deposited [J'] on the front surface, not on the rear surface.

Finally, the process of rear and front side metal printing and firing [K] is carried out.

Figure 2 shows a cross-section of a first back-contacted solar cell 1A manufactured according to the first process 100.

The back-contacted solar cell 1A comprises a substrate 10 as base. In an embodiment, the first conductivity type of the substrate is n-type.

On the rear surface BSF areas 12 have been created, which are patterned by a recess 7 in the rear surface of the substrate, i.e., the BSF layer is locally removed at the location of the recess. On top of the rear surface BSF areas 12 a barrier layer 11 arranged for protection against the laser damage removal process [P'] is located.

Within the recess 7 a via hole 5 extending between the front and rear surfaces of the substrate has been created.

On the front surface the solar cell 1A comprises an emitter area 14 adjacent to the base of the substrate 10. On top of the emitter area 14, a passivation layer 16 is present.

Due to application of the passivation process [H'] after creating the recess 7 by laser ablation and creation of the via holes 5 by the laser drilling process, via walls 10a and the recess area 7 are also covered by the passivation layer. The passivation layer can be silicon dioxide that is formed by a wet chemical oxidation process or thermal oxidation process.

The ARC layer 18 may be present on the passivation layer 16 on the front surface and on the via walls. Note that if the passivation layer is a silicon nitride layer, a separate ARC layer is not required.

It is noted that the BSF areas 12 are connected to electrodes of the first conductivity type polarity (not shown). In the via hole 5 a metal plug (not shown) is created as electrode of the second conductivity type polarity. Note that if the solar cell is an MWT type solar cell, a metal grid (not shown) is arranged on the front surface of the solar cell.

The recesses 7 are to have a depth at least equal to or larger than the thickness of the rear surface doped layer, i.e. the back surface field layer. Due to the recess formation the isolation of the metallization of the metal plug from the BSF area is advantageously enhanced.

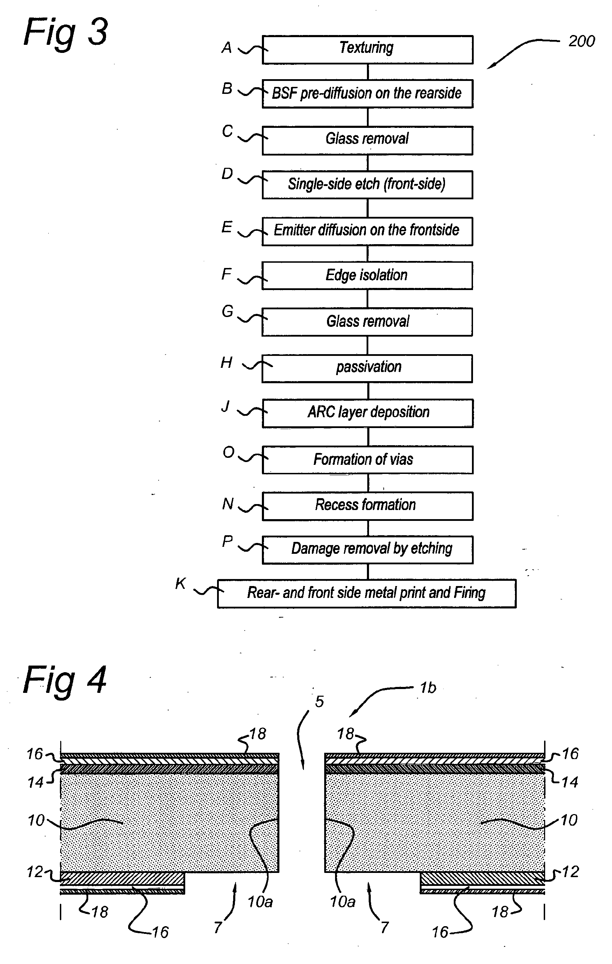

Figure 3 shows a flow diagram of a second process 200 for manufacturing a back-contacted solar cell in accordance with the present invention.

The structure of the solar cell being manufactured by this second process 200 will be illustrated with reference to figure 4.

According to the second process 200, a back-contacted solar cell is manufactured as follows.

A silicon semiconductor wafer of a first conductivity type is provided as substrate.

In a first step, a texturing process [A] is carried out to create a textured front surface of a silicon wafer.

Next, a pre-diffusion process [B] is carried out on the rear surface to create a first pre-doped area also of the first conductivity type, which will function as back surface field BSF. Typically, this process is carried out in a front-to-front configuration of the silicon wafer in combination with another silicon wafer.

In a next step, a glass removal process [C] is carried out to remove any glass or silicate layer that was used as dopant source layer in the pre-diffusion process [B].

Then, a single side etch [D] is carried out to etch the front surface so as to remove any parasitic BSF area from the front surface.

Next, the step to create the emitter area is carried out [E]. The emitter area is arranged to have a second conductivity type opposite to the first conductivity type.

The formation of the emitter area is followed by the step [F] to isolate the wafer edge by e.g. plasma etching, laser isolation or grinding. Both steps [E], [F] are similar to those of the prior art as described above.

Subsequently, a glass removal step [G] is carried out to remove any glass or silicate layer from front and rear surfaces.

Then, a passivation layer is deposited [H] on front and/or rear surfaces.

Further, an ARC layer is deposited [J] on the front and rear surfaces. The front side ARC layer may have a similar or different thickness than the rear surface ARC layer. The compositions of the front and rear surface ARC layer may be either similar or different from each other.

The ARC layers also fulfill a role as barrier layers.

Subsequently, a laser drilling process [O] is carried out to create the via holes in the substrate, cutting through any layer present on the substrate.

In a further step, a laser ablation process [N] is carried out to create recesses in the rear surface BSF layer to pattern the BSF layer. The recesses are arranged in such a way that is beneficial for fill factor and convenient for cell metallization pattern and cell interconnection. Each recess is created so as to remove the BSF layer in the area of the recess. In that manner the recess area is electrically isolated from adjacent BSF areas.

It is noted that typically each via hole is positioned within an associated recess area.

The laser drilling process and the laser ablation process may be carried out as separate successive processes. Alternatively, the laser drilling process and the laser ablation process may be carried out in alternation for each individual via hole and its associated recess area.

In yet a further step, an etching process [P] for laser damage removal and removal of dopant residues if present is carried out in a similar manner as described above with reference to the first process.

Finally, the process of rear and front side metal printing and firing [K] is carried out.

Figure 4 shows a cross-section of a second back-contacted solar cell 1B manufactured according to the second process 200.

The back-contacted solar cell 1B comprises a substrate 10 as base. In an embodiment, the conductivity of the substrate is n-type.

On the rear surface BSF areas 12 have been created which are patterned by a recess 7 in the rear surface of the substrate, i.e., the BSF layer is locally removed at the location of the or each recess. The depth of the recess 7 is at least equal to or larger than the thickness of the BSF layer 12.

Within the recess 7, a via hole 5 between the front and rear surfaces has been created.

On the front surface the solar cell 1A comprises an emitter area 14 adjacent to the base of the substrate 10.

On top of the emitter area 14 and the BSF area 12, a passivation layer 16 is present.

The ARC layer 18 is present on the passivation layer 16 on the front surface and on the rear surface.

The passivation layer 16 and the ARC layer 18 have been deposited on both the front and rear surface before laser drilling of the via holes and laser ablation to create recesses in the rear surface. As a, result the via walls 10a and the recess area 7 are free of any passivation layer or ARC layer.

It is noted that the BSF areas 12 are connected to electrodes of the first conductivity type polarity (not shown). In the via hole 5 a metal plug (not shown) is created as electrode of the second conductivity type polarity. Due to the recess the isolation of the metallization of the metal plug from the BSF area is advantageously enhanced.

The depth of the recesses 7 is at least equal to or larger than the thickness of the rear surface doped layer (BSF layer) 12.

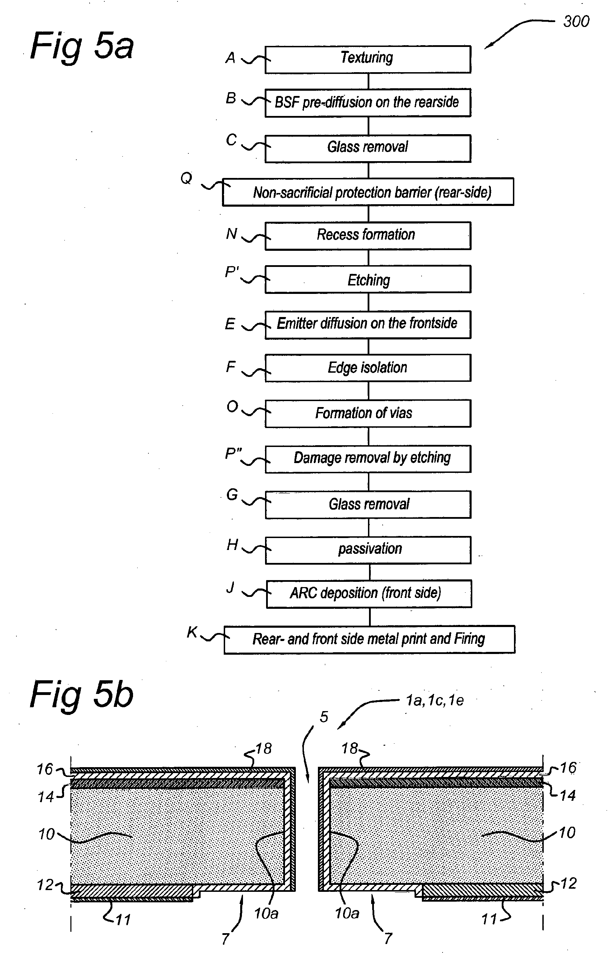

Figure 5a shows a flow diagram of a third process 300 for manufacturing a back-contacted solar cell in accordance with the present invention.

The structure of the solar cell being manufactured by this third process 300 will be illustrated with reference to figure 5b.

According to the third process, a back-contacted solar cell is manufactured as follows.

A silicon semiconductor wafer of a first conductivity type is provided as substrate.

Initially, a texturing process [A] is carried out to create a textured front surface of a silicon wafer.

Next, a pre-diffusion process [B] is carried out on the rear surface to create a first pre-doped area, also of the first conductivity type, which will function as back surface field BSF.

Subsequently, a glass removal process [C] is carried out to remove any glass or silicate layer that was used as dopant source layer in the pre-diffusion process [B].

According to an embodiment of the present invention, a subsequent step comprises a barrier layer deposition process [Q] for depositing a barrier layer on the rear surface. The barrier layer is arranged as barrier against etching of silicon. In an embodiment, the barrier layer is is a non-sacrificial layer containing for example silicon nitride or aluminum oxide.

In a further step, a laser ablation process [N] is carried out to create recesses in the rear surface BSF layer to pattern the BSF layer. The recesses are arranged in such a way that is beneficial for fill factor and convenient for cell metallization pattern and cell interconnection. Each recess is created so as to remove the BSF layer in the area of the recess. In that manner the recess area is electrically isolated from adjacent BSF areas.

Next, an etching process [P'] for laser damage removal and removal of dopant residues if present is carried out. During this etching step [P'], the rear surface of the substrate is protected by the barrier layer deposited in preceding barrier deposition step [Q]. At the same time, the etching process is arranged to limit or prevent too much etching damage to the front surface texture. In an embodiment, the barrier layer is a non-sacrificial layer containing for example silicon nitride or aluminum oxide.

Subsequently, the step to create the emitter area is carried out [E]. This process [E] may be carried out in a back-to-back configuration. The emitter area is arranged to have a second conductivity type opposite to the first conductivity type.

Next, an edge isolation step is carried out to prevent short-circuiting front and rear surfaces of the solar cell.

Then, a laser drilling process [O] is carried out to create the via holes.

It is noted that typically each via hole is positioned within an associated recess area created in earlier step [N].

Then, a second etching process [P"] for laser damage removal and removal of any dopant residues is carried out while the rear surface of the substrate is still protected by the barrier layer that was deposited in preceding barrier deposition step [Q]. During this process dopant residues if present are removed.

Next, a glass removal step [G] is carried out to remove any glass or silicate layer from front and rear surfaces.

Then, a passivation layer is deposited [H] on the front and rear surfaces of the substrate.

Further, an ARC deposition process [J'] is carried out to deposit an ARC layer on the front surface only, not necessarily on the rear surface.

Finally, the process of rear and front side metal printing and firing [K] is carried out.

The back-contacted solar cell 1C manufactured according to the third process 300 is illustrated by figure 5b.

The back-contacted solar cell 1C comprises a substrate 10 as base. In an embodiment, the first conductivity of the substrate is n-type.

On the rear surface of the substrate BSF areas 12 have been created, which are patterned by a recess 7 in the rear surface of the substrate, i.e., the BSF layer is locally removed at the location of the or each recess. The depth of the recess 7 is at least equal to or larger than the thickness of the BSF layer 12 after pre-diffusion.

On top of the rear surface BSF areas 12 a barrier layer 11 arranged for protection against the etching process for damage and/or dopant residue removal [P'] and [P"] is located. In case this barrier layer 11 is a silicon nitride layer or other suitable dielectric/passivating layer, it may function at a later stage as ARC layer.

Within the recess area 7, a via hole 5 which extends between the front and the rear surface of the substrate has been created.

On the front surface the solar cell 1C comprises an emitter area 14 adjacent to the base of the substrate 10. On top of the emitter area 14, a passivation layer 16 is present.

Due to application of the passivation process [H'] after creating the recess 7 and creation of the via holes 5, via walls 10a and the recess area 7 are also covered by the passivation layer.

The ARC layer 18 is present on the passivation layer 16 on the front surface and on the via walls 10a. Since the ARC layer 18 was not deposited on the rear surface, the rear surface is substantially free from the ARC layer 18, but it contains the barrier layer 11.

It is noted that the BSF areas 12 are connected to electrodes of the first conductivity type polarity (not shown). In the via hole 5 a metal plug (not shown) is created as electrode of the second conductivity type polarity. Due to the recess 7 the isolation of the metallization of the metal plug from the metallization of the BSF area 12 is advantageously enhanced.

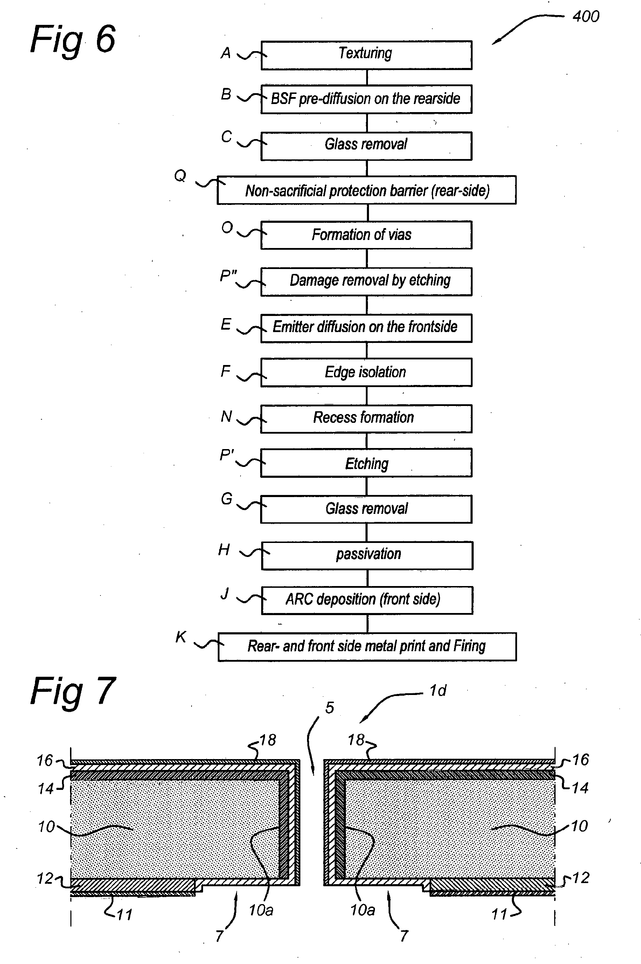

Figure 6 shows a flow diagram of a fourth process 400 for manufacturing a back-contacted photovoltaic cell in accordance with the present invention.

The structure of the solar cell being manufactured by this fourth process 400 will be illustrated with reference to figure 7.

According to the fourth process, a back-contacted solar cell is manufactured as follows.

A silicon semiconductor wafer of a first conductivity type is provided as substrate.

Initially a texturing process [A] is carried out to create a textured front surface of a silicon wafer.

In a next step, a pre-diffusion process [B] is carried out on the rear surface to create a first pre-doped area of the first conductivity type which will function as back surface field BSF.

Then, a glass removal process [C] is carried out to remove any glass or silicate layer that was used as dopant source layer in the pre-diffusion process [B].

According to an embodiment of the present invention, a subsequent step comprises a barrier layer deposition process [Q] for depositing a barrier layer on the rear surface. The barrier layer is arranged as barrier against etching of silicon. In an embodiment, the barrier layer is a non-sacrificial layer containing for example silicon nitride or aluminum oxide.

In a further step, a laser drilling process [O] is carried out to create the via holes.

Next, an etching process [P"] for laser damage removal is carried out. Additionally, parasitic diffusion on the front surface may be removed. During this etching step [P"], the rear surface of the substrate is protected by the barrier layer deposited in preceding barrier deposition process step [Q]. At the same time, the etching process is arranged to prevent etching damage to the front surface texture.

Subsequently, the step to create the emitter area is carried out [E], while the pre-doped area on the rear surface (i.e., the BSF layer) may be co-diffused. The emitter area has a second conductivity type, opposite to the first conductivity type of the substrate.

The formation [E] of the emitter area is followed by the step [F] to isolate the wafer edge by e.g., plasma etching, laser edge isolation or grinding.

Then, a laser ablation process [N] is carried out to create recesses in the rear surface BSF layer by locally removing the BSF layer. The recesses are arranged in such a way that is beneficial for fill factor and convenient for cell metallization pattern and cell interconnection. Each recess is created so as to remove the BSF layer in the area of the recess. In that manner the recess area is electrically isolated from adjacent BSF areas.

It is noted that typically via hole created in earlier step [O]is positioned within an associated recess area.

Then, a second etching process [P'] for laser damage removal and dopant residues if present is carried out while the rear surface of the substrate is still protected by the barrier layer that was deposited in preceding barrier deposition process step [Q].

Next, a glass removal step [G] is carried out to remove any glass or silicate layer from front and rear surfaces.

Then, a passivation layer is deposited [H] on the front and rear surfaces of the substrate, the via holes and in the recesses.

Further, an ARC layer is deposited [J'] on the front surface only, not on the rear surface.

Finally, the process of rear and front side metal printing and firing [K] is carried out.

Figure 7 shows a cross-section of a fourth back-contacted solar cell 1D manufactured according to the fourth process 400.

The back-contacted solar cell 1D comprises a substrate 10 as base. In an embodiment, the first conductivity type of the substrate is n-type.

On the rear surface of the substrate BSF areas 12 have been created, patterned by a recess 7 in the rear surface of the substrate, i.e., the BSF layer is locally removed at the location of the or each recess. The depth of the recess 7 is at least equal to or larger than the thickness of the BSF layer 12.

On top of the rear surface BSF areas 12 a barrier layer 11 arranged for protection against the etching process [P] for removal of laser damage and any dopant residues is located.

Within the recess area 7, a via hole 5 extending between the front and rear surfaces has been created.

On the front surface the solar cell 1D comprises an emitter area 14 adjacent to the base of the substrate 10. The emitter area 14 also extends along the via walls 10a. On top of the emitter area 14, a passivation layer 16 is present, also extending along the via walls 10a.

The ARC layer 18 is present on the passivation layer 16 on the front surface and on the via walls 10a. Since the ARC layer 18 was not deposited on the rear surface, the rear surface is substantially free from the ARC layer.

Also, since both the front and rear surface were exposed in the passivation layer deposition process, the BSF areas 12 and the recess area 7 on the rear surface are covered by the passivation layer 16.

It is noted that the BSF areas 12 are connected to electrodes of the first conductivity type polarity (not shown). In the via hole 5 a metal plug (not shown) is created as electrode of the second conductivity type polarity. Due to the recess the isolation of the metallization of the metal plug from the metallization of the BSF area is advantageously enhanced.

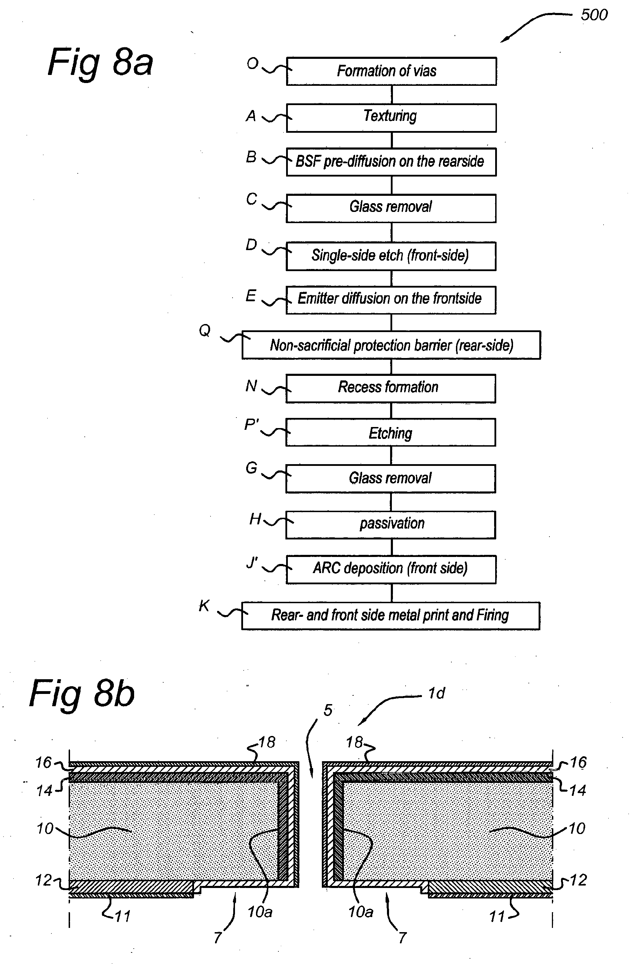

Figure 8a shows a flow diagram of a fifth process 500 for manufacturing a back-contacted solar cell in accordance with the present invention.

The structure of the solar cell being manufactured by this fifth process 500 will be illustrated with reference to figure 8b.

According to the fifth process, a back-contacted solar cell is manufactured as follows.

A silicon semiconductor wafer of a first conductivity type is provided as substrate.

Initially, a laser drilling process [O] is carried out to create the via holes.

Then, a texturing process [A] is carried out to create a textured front surface of a silicon wafer.

Next, a pre-diffusion process [B] is carried out on the rear surface to create a first pre-doped area (of the first conductivity type) which will function as back surface field BSF.

A glass removal process [C] is carried out to remove any glass or silicate layer that was used as dopant source layer in step [B].

Subsequently, a single sided etch process [D] of the front side of the substrate is carried out.

Next, the step to create the emitter area (of a second conductivity type opposite to the first conductivity type) is carried out [E], while the pre-doped area on the rear surface (i.e., the BSF layer) may be co-diffused.

According to an embodiment of the present invention, a subsequent step comprises a barrier layer deposition process [Q] for depositing a barrier layer on the rear surface. The barrier layer is arranged as barrier against etching of silicon. In an embodiment, the barrier layer is a non-sacrificial layer containing for example silicon nitride or aluminum oxide.

In a further step, a laser ablation process [N] is carried out to create recesses in the rear surface to pattern the BSF layer. The recesses are arranged in such a way that is beneficial for fill factor and convenient for cell metallization pattern and cell interconnection. Each recess is created so as to remove the BSF layer in the area of the recess. In that manner the recess area is electrically isolated from adjacent BSF areas.

It is noted that typically each via hole created in earlier step [O] is positioned within an associated recess area.

Then, an etching process [P'] for laser damage removal and removal of dopant residues if present is carried out. During this etching step [P'], the rear surface of the substrate is protected by the barrier layer deposited in preceding barrier deposition process step [Q].

Next, a glass removal process [G] is carried out to remove any glass or silicate layer from front and rear surfaces.

Then, a passivation layer is deposited [H] on the front and rear surfaces of the substrate. The passivation layer is deposited on the front and rear surface, on the walls of via holes and in the recesses.

Further, an ARC layer is deposited [J'] on the front surface only, not on the rear surface.

Finally, the process of rear and front side metal printing and firing [K] is carried out.

The back-contacted solar cell 1E manufactured according to the fifth process 500 is illustrated by figure 7 above.

The back-contacted solar cell 1E comprises a substrate 10 as base. In an embodiment, the first conductivity type of the substrate is n-type.

On the rear surface of the substrate BSF areas 12 have been created, which are patterned by a recess 7 in the rear surface of the substrate, i.e., the BSF layer is locally removed at the location of the or each recess. The depth of the recess 7 is at least equal to or larger than the thickness of the BSF layer 12.

On top of the rear surface BSF areas 12 a barrier layer 11 arranged for protection against the laser damage removal process [P'] is located. If the barrier layer is a dielectric layer such as a silicon nitride layer, it may serve as ARC layer.

Within the recess area 7, a via hole 5 that extends between the front surface and rear surface of the substrate has been created.

On the front surface the solar cell 1E comprises an emitter area 14 adjacent to the base of the substrate 10. The emitter area 14 also extends along the via walls 10a. On top of the emitter area 14, a passivation layer 16 is present, also extending along the via walls 10a.

The ARC layer 18 is present on the passivation layer 16 on the front surface and on the via walls 10a. Since the ARC layer 18 was not deposited on the rear surface, the rear surface is substantially free from the ARC layer.

Also, since both the front and rear surface were exposed in the passivation layer deposition process, the BSF areas 12 and the recess area 7 on the rear surface are covered by the passivation layer 16.

It is noted that the BSF areas 12 are connected to electrodes of the first conductivity type polarity (not shown). In the via hole 5 a metal plug (not shown) is created as electrode of the second conductivity type polarity. Due to the recess 7, the isolation of the metallization of the metal plug from the metallization of the BSF area is advantageously enhanced.

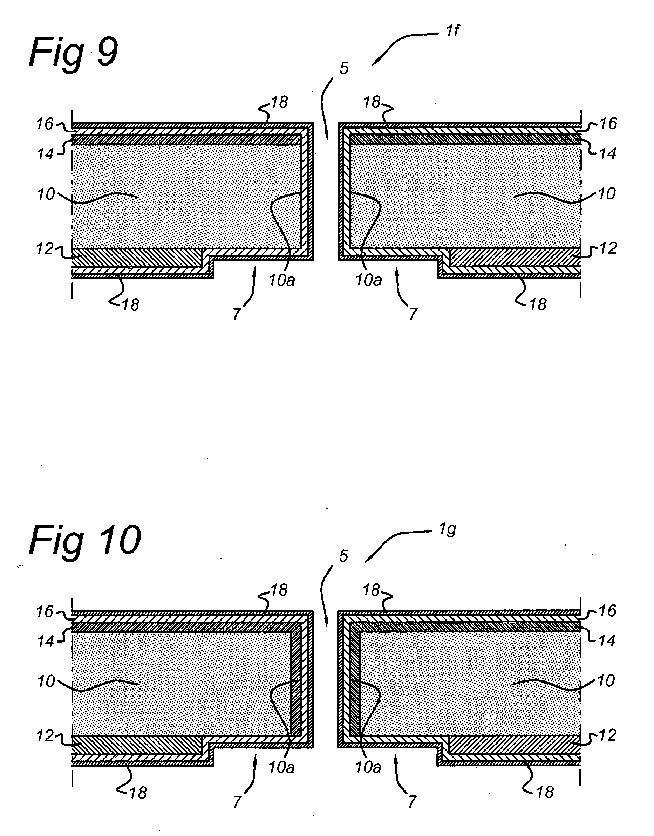

An embodiment which is an alternative to process flow 500 will apply a sacrificial patterned protection barrier after pre-diffusion step [B] or glass removal step [C], but before single side etch step [D]. The single side etch step [D] will in this case be replaced by a 2-sided etching step which removes parasitic dopants from the front side as well as pre-diffused BSF-areas from the rear side, where the protection barrier is absent. In this embodiment, after emitter diffusion [E] parasitic emitter diffusion will be present in the recess areas, and therefore a via isolation step is preferably done at some point after emitter diffusion. For example, this isolation can be done by laser scribing inside the recess, but outside the via and associated metallization. The structure is similar to Fig. 10, however, with emitter layer 14 present also in the recess. The depth of the recess is at least as great as the thickness of the pre-diffused BSF layer.

The process flows 100, 200, 300, 400, 500 as described above relate to embodiments that comprise a barrier layer deposition process [Q], or [M] in process flow 100, or [J] in process flow 200, for depositing a non-sacrificial barrier layer (such as silicon nitride or aluminum oxide or SiOx or a stack of such materials) on the rear surface. Preferably, such a barrier layer also has favorable properties for passivation of the rear surface against carrier recombination, and favorable optical properties to enhance rear side reflection of light back into the silicon wafer (in short described as an 'ARC layer' in the previous embodiments).

In process flows 100, 300, 400, 500, typically a diffusion glass layer can be used as a sacrificial protection barrier on the front surface. However, also a non-sacrificial protection barrier layer can be used on the front side, similar to the description in process flow 200. If a non-sacrificial protection barrier layer is used on the front side, that layer preferably has favorable properties for passivation of the front surface against carrier recombination, and favorable anti-reflecting optical properties. Unless followed by another coating deposition after creation of the via holes, in process flows 100, 300, 400, 500 this will result in the passivating and coating layers not being present on the surface of the via hole.

Alternatively to a non-sacrificial barrier layer, a barrier layer deposition process may be applied which deposits a sacrificial barrier layer.

In an embodiment, the sacrificial barrier deposition process comprises a spin-on deposition of a silicon containing liquid such as a Silanol-based liquid, followed by a heat treatment (baking and curing) to form a silicon oxide layer as barrier. In yet another embodiment, the sacrificial barrier deposition process comprises a thermal oxidation process to form a thin silicon dioxide on the surfaces of the substrate, e.g. by oxidation of the boron rich top layer after emitter diffusion on an n-type wafer. The skilled person will appreciate that other materials and/or other deposition or formation techniques can be applied as well as alternative sacrificial barrier deposition techniques. In an embodiment, the barrier may comprise a printable etch resist layer.

When applying a sacrificial barrier layer in the barrier deposition process step [Q], or [M] in process flow 100, or [J] in process flow 200, the process flows 100, 200, 300, 400, 500 are to be slightly modified. The sacrificial barrier will be removed after damage removal process [P], [P'] or [P"]. Depending on the nature of the barrier, it may be removed by a wet chemical process. The ARC deposition step [J] or [J'] will typically be on rear as well as front side.

In process flow 200, after removal of the sacrificial barrier layers, ARC layers will have to be deposited.

One particular modification of the process flows when a sacrificial barrier layer is applied, but not applicable to process flow 200, is as follows:
1) The texturing process [A] is replaced by a single-side polishing process [A'] for polishing the rear surface of the substrate.
2) The single side etch [D], if present in the process flow, is omitted.
3) Then the barrier layer deposition process [M] or [Q] for depositing a non-sacrificial barrier layer on the rear surface is replaced by the alternative barrier layer deposition process [Q'] for depositing a sacrificial barrier layer on both surfaces of the substrate; deposited before emitter formation.
4) Additionally, before the step to create the emitter area [E] is carried out, a front side texturing process [A2] is carried out. The front side texturing process [A2] is arranged to remove the sacrificial barrier layer from the front surface, at the same time remove any parasitic BSF layer from the rear surface and to create a texture on the front surface of the substrate.
5) Finally, when using a sacrificial barrier layer, the deposition process [J] for an anti refection coating (ARC) layer is carried out to create an ARC layer on both surfaces of the silicon wafer.

Figure 9 shows a cross-section of a further back-contacted solar cell 1F manufactured according to either the first or third process when the sacrificial barrier layer is applied.

The back-contacted solar cell 1F comprises a substrate 10 as base. In an embodiment, the first conductivity type of the substrate is n-type.

On the rear surface BSF areas 12 have been created, which are patterned by a recess 7 in the rear surface of the substrate, i.e., the BSF layer is locally removed at the location of the or each recess. The depth of the recess 7 is at least equal to or larger than the thickness of the BSF layer 12.

Within the recess 7 a via hole 5 extending between the front and rear surfaces of the substrate has been created.

On the front surface the solar cell 1F comprises an emitter area 14 adjacent to the base of the substrate 10. On top of the emitter area 14, a passivation layer 16 is present.

The passivation layer 16 is also present on the via walls 10a and the rear surface of the solar cell.

The ARC layer 18 is present on the passivation layer 16 on the front surface, the via walls and on the rear surface.

Figure 10 shows a cross-section of yet a further back-contacted solar cell 1G manufactured according to either the fourth or fifth process, when the sacrificial barrier layer is used.

The back-contacted solar cell 1G comprises a substrate 10 as base. In an embodiment, the first conductivity type of the substrate is n-type.

On the rear surface of the substrate BSF areas 12 have been created, which are patterned by a recess 7 in the rear surface of the substrate, i.e., the BSF layer is locally removed at the location of the or each recess. The depth of the recess 7 is at least equal to or larger than the thickness of the BSF layer 12..

Within the recess area 7, a via hole 5 extending between the front and rear surfaces has been created.

On the front surface the solar cell 1G comprises an emitter area 14 adjacent to the base of the substrate 10. The emitter area 14 also extends along the via walls 10a. On top of the emitter area 14, a passivation layer 16 is present, also extending along the via walls 10a.

Further the passivation layer 16 is also present on the rear surface of the solar cell.

The ARC layer 18 is present on the passivation layer 16 on the front surface, the via walls and on the rear surface.

Furthermore, it is noted that in an alternative embodiment, the via holes may be created by either water jet drilling or laser chemical processing instead of laser drilling.

In yet another embodiment, the creation of the via holes in combination with the creation of the vias is embodied by a thermomigration process.

Moreover, the laser drilling process may be a water jet guided laser drilling process.

The recesses formation on the rear surface may be done by laser ablation or other laser-assisted method, as described in the previous embodiments. Alternatively the recesses can be created by other lithographic processes described in the literature, such as, for example, applying an etching material in a pattern by screen or stencil printing or similar techniques, or by inkjet or other jetting techniques, or applying an etching mask in a pattern by screen or stencil printing or similar techniques, or inkjet or other jetting techniques followed by wet chemical or plasma etching process, or by photolithography followed by wet chemical or plasma etching, etc.

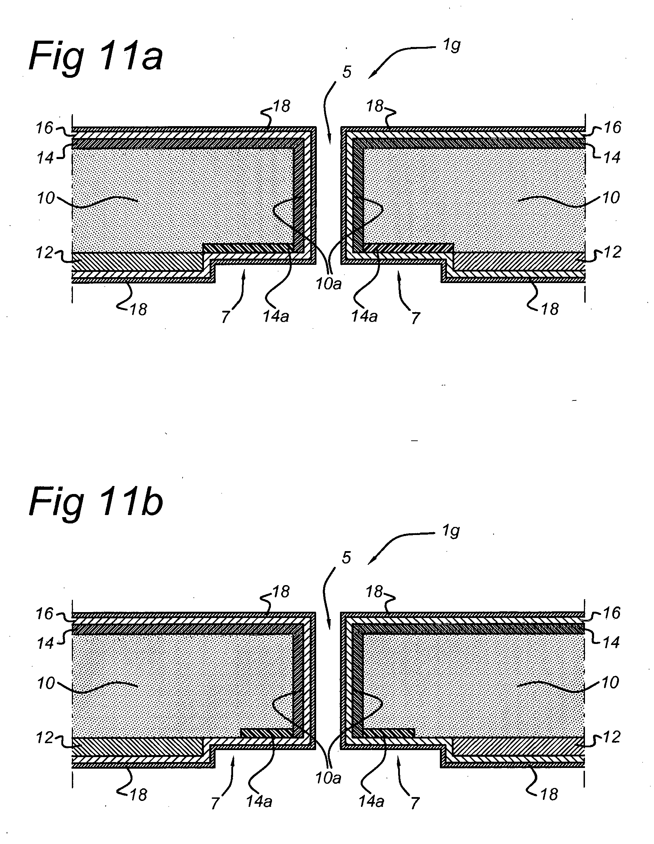

Figure 11A and 11B show further embodiments of solar cells according to the invention.

In an embodiment of the solar cell according to the present invention, it is feasible that the emitter area 14 can also extend as a extended emitter layer 14A on the rear side of the substrate at the location of the recesses 7 where the BSF layer is removed.

This can be achieved in the embodiments as shown in fig 11A and 11B when the recesses in the rear surface are created in the rear surface doped layer preceding the creation of the front surface doped layer, and the via holes in the substrate are created after creation of the rear surface doped layer but preceding the creation of the front surface doped layer.

The emitter layer extension 14A along the via walls and on the rear side at the location of the recess 7 where the BSF layer is removed advantageously enhances the isolation of the contacting electrode of the second conductivity type from the substrate of first conductivity type. It will be appreciated by the skilled person that the extension of the emitter layer on the rear side at the recesses location is made possible thanks to the removal of the BSF layer and using suitable diffusion techniques such as, e.g., vapor state diffusion technique as part of the formation of the emitter layer. If the BSF layer were not removed inside the recess, the emitter dopant atoms would be at least partly compensated by the BSF dopant atoms, which would degrade the isolation.

Additionally, the diffusion techniques allow to define the length of the emitter layer extension 14A extending from the via hole along the recess area 7. In fig 11A the emitter layer extension 14A has been manufactured to extend along substantially the complete recess area, while in figure 11B the emitter layer extension 14A extend from the via hole along a smaller portion of the recess area 7.

It is noted that the depth of the recess area 7 is at least equal to, or larger than, the thickness of the BSF layer 12, or the thickness of the rear doped layer after pre-diffusion, if a process flow including a pre-diffusion is used for this layer.

Moreover, it is noted that it may be possible to combine the passivation layer and the ARC layer in one coating layer. For example, a silicon nitride layer on a phosphorous diffused emitter layer is known to have both good passivating and good anti-reflective properties.

It is noted that depending on the method for deposition of the passivating layer, the passivating layer may or may not be deposited inside the via or on the surface of the recess on the rear. For example, when depositing a passivating layer by wet-chemical oxidation, it will be deposited inside the via and on the surface of the recess. When depositing a passivating layer on the front side by PECVD it will typically be deposited only on part of the inside of the via and not on the surface of the recess.

It is noted that when adding a deposition of a coating layer on the rear surface, for example in process flow 100 after step [H'], 200 after step [P], 300, 400, 500 after step [J] or [J'], the surface of the recess will be covered by coating layer 18, and the resulting structure will be similar to Fig. 9 or 10. Such a coating may be advantageous to improve surface passivation of the recess and via hole, and isolation in the via hole.

It is noted that metallization may be applied on the surface of the recess, to enable interconnection of the vias, and/or interconnection of the solar cells.

It is noted that the cross section of the solar cell may be modified from the Figures shown, due to metallization and firing. In particular, alloying of the metallization in the via with the silicon of the surface of the via hole, may result in a passivating layer or a diffused emitter layer on the via surface to be no longer noticeable.

It is noted that recess depth can be close to the BSF thickness or larger. Figure 2 and figure 5b illustrate this variation in depth which is possible for all process flows.

It will be apparent to the person skilled in the art that other embodiments of the invention can be conceived and reduced to practice without departing form the true spirit of the invention, the scope of the invention being limited only by the appended claims as finally granted. The description is not intended to limit the invention.

The following clauses define various aspects of the present invention.
Clause 1. Method for manufacturing a solar cell comprising providing a silicon semiconductor substrate of a first conductivity type, the substrate having a front and a rear surface;
   the method comprising:
   - creating on the rear surface a doped layer of the first conductivity type in the silicon semiconductor substrate, as rear surface doped layer for functioning as back surface field layer in the solar cell;
   - creating on the front surface a doped layer of a second conductivity type as front surface doped layer for functioning as an emitter layer in the solar cell, the second conductivity type being opposite to the first conductivity type; wherein the method further comprises:
      creating recesses in the rear surface by removal of the rear surface doped layer in the silicon semiconductor substrate at the location of the recesses to pattern the rear surface doped field layer of the first conductivity type so as to create back surface field areas, the recesses being void of rear surface doped layer material and the recesses having a depth at least equal to or larger than the thickness of the rear surface doped layer and
      creating via holes in the substrate, each via hole being positioned within an associated recess.
Clause 2. Method according to Clause 1 wherein the via holes are created by one process selected from a group comprising laser drilling, water jet-guided laser drilling, laser chemical drilling, suspended abrasive water jet hole drilling.
Clause 3. Method according to clause 1, wherein the rear surface doped layer is created by a pre-diffusion process.
Clause 4. Method according to clause 1, wherein the rear surface doped layer is created by a pre-diffusion process, and during formation of the front surface doped area is co-diffused to form the back surface field layer.
Clause 5. Method according to clause 1, wherein the creation of the recesses is done by one process selected from a group comprising laser ablation, water jet-guided laser ablation, laser chemical ablation, suspended abrasive water jet ablation, and lithography.
Clause 6. Method according to any one of clauses 1 - 5, wherein
   the recesses in the rear surface are created after the creation of the front surface doped layer on the front surface and the rear surface doped layer on the rear surface, and
   the via holes in the substrate are created after the creation of the front surface doped layer on the front surface and the rear surface doped layer on the rear surface.
Clause 7. Method according to any one of clauses 1 - 5, comprising - depositing an anti reflection coating layer on at least the front surface after the creation of the front surface doped area on the front surface, wherein the recesses in the rear surface are created after the deposition of the anti reflection coating layer, and the via holes in the substrate are created after the deposition of the anti reflection coating layer.
Clause 8. Method according to any one of clauses 1 - 5, wherein the via holes in the substrate are created preceding the creation of the rear surface doped layer, and
   the recesses in the rear surface are created after the creation of the front surface doped layer.
Clause 9. Method according to any one of clauses 1 - 5, wherein the via holes in the substrate are created preceding the creation of the rear surface doped layer, and
   the recesses in the rear surface are created before the creation of the front surface doped layer.
Clause 10. Method according to any one of clauses 1 - 5, wherein the via holes in the substrate are created after the creation of the rear surface doped layer but preceding the creation of the front surface doped layer, and the recesses in the rear surface are created after the creation of the front surface doped layer.
Clause 11. Method according to any one of clauses 1 - 5, wherein the recesses in the rear surface are created in the rear surface doped layer but preceding the creation of the front surface doped layer, and
   the via holes in the substrate are created after the creation of the front surface doped layer.
Clause 12. Method according to any one of clauses 1 - 5, wherein the recesses in the rear surface are created in the rear surface doped layer but preceding the creation of the front surface doped layer, and
   the via holes in the substrate are created after creation of the rear surface doped layer but preceding the creation of the front surface doped layer.
Clause 13. Method according to clause 1, further comprising:
   metal printing and firing for forming metallization patterns in accordance with the design of the solar cell and forming metal plugs in the via holes, the solar cell being of either EWT type or MWT type.
Clause 14. Method according to any one of the preceding clauses 2 - 13, wherein the creation of the via holes in the substrate by the laser hole drilling process is followed by:
   - etching the substrate to remove damaged substrate material.
Clause 15. Method according to any one of the preceding clauses 2 - 13, wherein the creation of the recesses in the rear surface is followed by:
   - etching the substrate to remove damaged substrate material and possible dopant residues.
Clause 16. Method according to any one of the preceding clauses 1 - 7 or any one of clauses 10 - 14 wherein the creation of the via holes is preceded by deposition of an etching protection barrier on either the rear or the front and rear surface.
Clause 17. Method according to any one of the preceding clauses 1 - 7 or any one of clauses 8-15 wherein the creation of the recesses is preceded by deposition of an etching protection barrier on either the rear or the front and rear surface.
Clause 18. Method according to clause 6 or 8 or 16 or 17 wherein the deposition of an etching protection barrier on the rear side precedes the creation of the front side doped layer.
Clause 19. Method according to clause 6 or 8 or 16 or 17 wherein the deposition of an etching protection barrier on the rear side follows the creation of the front side doped layer.
Clause 20. Method according to clause 16 or 17 wherein the etching protection barrier on the front surface is a dopant diffusion glass layer.
Clause 21. Method according to clause 16 or 17 wherein the etching protection barrier on the rear surface is created by a thermal oxidation process.
Clause 22. Method according to clause 16 or 17, wherein the etching protection barrier on the rear surface is a deposited etching protection barrier selected from a group comprising silicon nitride, silicon oxide, aluminium oxide, a dielectric, a stack of dielectric layers, and a resist material.
Clause 23. Method according to clause 1, wherein the creation of the via holes is combined with the creation of vias by a thermomigration process.
Clause 24. Method according to clause 12 or 15, wherein at least part of the rear surface area inside the recesses, connected to the via, is diffused with the same polarity as the front surface doped layer.
Clause 25. Method according to clause 24, wherein the rear surface area inside the recesses is diffused with at least 10¹³ cm⁻² of dopant atoms.
Clause 26. Back-contacted solar cell manufactured by a method according to any one of the preceding clauses 1 - 25; the solar cell comprising:
   a silicon semiconductor substrate having a front and a rear surface;
      - having on the rear surface a doped layer of the first conductivity type in the silicon semi substrate, as rear surface doped layer for functioning as back surface field layer in the solar cell;
      - having on the front surface a doped layer of a second conductivity type as front surface doped layer for functioning as an emitter layer in the solar cell, the second conductivity type being opposite to the first conductivity type;
   wherein:
      the rear surface comprises recesses that pattern the back surface field layer of the first conductivity type in back surface field areas, the recesses being void of back surface field layer material
      the substrate comprises via holes between the front and rear surfaces, the via holes being located within the recesses.
Clause 27. Back-contacted solar cell according to clause 26, wherein the solar comprises an anti reflection coating layer on the passivation layer on at least the front surface.
Clause 28. Back-contacted solar cell according to clause 26 or 27, where a depth of the recess is at least equal to or larger than the thickness of the rear surface doped layer.
Clause 29. Back-contacted solar cell according to any one of clauses 26 - 28, further comprising:
   a passivation layer on walls of the via holes, and
   an anti-reflection coating layer covering the passivation layer on the walls of the via hole.
Clause 30. Back-contacted solar cell according to any one of clauses 26 - 29, further comprising:
   an emitter layer on walls of each via hole, and
   the emitter layer on the walls of the via holes being covered by a passivation layer;
   the passivation layer being covered by an anti reflection coating layer.
Clause 31. Back-contacted solar cell according to clause 29 or 30, further comprising:
   an emitter layer on the rear side at the location of the recesses where the back surface field layer is removed, connected to the emitter layer on walls of each via hole.
Clause 32. Back-contacted solar cell according to any one of clauses 26 - 31,
   wherein the back surface field areas are covered by a protection barrier layer and the recessed areas are not covered by the protection barrier layer.
Clause 33. Back-contacted solar cell according to any one of clauses 26 - 32 wherein the front or rear surface is textured with random pyramid texture, and where the front or rear surface is at least partly smoothened.
Clause 34. Back-contacted solar cell according to clause 33, wherein the at least partial smoothening includes at least one of a broadening and a rounding of intermediate valleys between pyramidal shapes of the textured surface.
Clause 35. Back-contacted solar cell according to clause 34, wherein the textured and partially smoothened surface comprises a pyramidal shapes containing surface with intermediate valleys having widths selected from the range of 50-500 nm.
Clause 36. Back-contacted solar cell according to clause 34, wherein the textured and partially smoothened surface having valleys with curvatures having radii selected from the range of 25-250 nm.

## Claims

1. Method for manufacturing a solar cell comprising providing a silicon semiconductor substrate of a first conductivity type, the substrate having a front and a rear surface;
the method comprising:
- creating on the rear surface a doped layer of the first conductivity type in the silicon semiconductor substrate, as rear surface doped layer for functioning as back surface field layer in the solar cell;
- creating on the front surface a doped layer of a second conductivity type as front surface doped layer for functioning as an emitter layer in the solar cell, the second conductivity type being opposite to the first conductivity type;
wherein the method further comprises:
creating recesses in the rear surface by removal of the rear surface doped layer in the silicon semiconductor substrate at the location of the recesses to pattern the rear surface doped field layer of the first conductivity type so as to create back surface field areas, the recesses being void of rear surface doped layer material and the recesses having a depth at least equal to or larger than the thickness of the rear surface doped layer and
creating via holes in the substrate, each via hole being positioned within an associated recess.

2. Method according to claim 1, wherein the rear surface doped layer is created by a pre-diffusion process.

3. Method according to claim 1, wherein the rear surface doped layer is created by a pre-diffusion process, and during formation of the front surface doped area is co-diffused to form the back surface field layer.

4. Method according to claim 1, wherein the creation of the recesses is done by one process selected from a group comprising laser ablation, water jet-guided laser ablation, laser chemical ablation, suspended abrasive water jet ablation, and lithography.

5. Method according to any one of claims 1 - 4, wherein
the recesses in the rear surface are created after the creation of the front surface doped layer on the front surface and the rear surface doped layer on the rear surface, and
the via holes in the substrate are created after the creation of the front surface doped layer on the front surface and the rear surface doped layer on the rear surface.

6. Method according to any one of claims 1 - 4, comprising - depositing an anti reflection coating layer on at least the front surface after the creation of the front surface doped area on the front surface, wherein the recesses in the rear surface are created after the deposition of the anti reflection coating layer, and the via holes in the substrate are created after the deposition of the anti reflection coating layer.

7. Method according to any one of claims 1 - 4, wherein the via holes in the substrate are created preceding the creation of the rear surface doped layer, and
the recesses in the rear surface are created after the creation of the front surface doped layer.

8. Method according to any one of claims 1 - 4, wherein the via holes in the substrate are created preceding the creation of the rear surface doped layer, and
the recesses in the rear surface are created before the creation of the front surface doped layer.

9. Method according to any one of claims 1 - 4, wherein the via holes in the substrate are created after the creation of the rear surface doped layer but preceding the creation of the front surface doped layer, and
the recesses in the rear surface are created after the creation of the front surface doped layer.

10. Method according to any one of claims 1 - 4, wherein the recesses in the rear surface are created in the rear surface doped layer but preceding the creation of the front surface doped layer, and
the via holes in the substrate are created after the creation of the front surface doped layer.

11. Method according to any one of claims 1 - 4, wherein the recesses in the rear surface are created in the rear surface doped layer but preceding the creation of the front surface doped layer, and
the via holes in the substrate are created after creation of the rear surface doped layer but preceding the creation of the front surface doped layer.

12. Method according to any one of the preceding claims 1 - 6 or any one of claims 9 - 11 wherein the creation of the via holes is preceded by deposition of an etching protection barrier on either the rear or the front and rear surface.

13. Method according to any one of the preceding claims 1 - 6 or any one of claims 7 - 11 wherein the creation of the recesses is preceded by deposition of an etching protection barrier on either the rear or the front and rear surface.

14. Method according to claim 5 or 7 or 12 or 13 wherein the deposition of an etching protection barrier on the rear side precedes the creation of the front side doped layer.

15. Method according to claim 5 or 7 or 12 or 13 wherein the deposition of an etching protection barrier on the rear side follows the creation of the front side doped layer.

16. Method according to claim 1, wherein the creation of the via holes is combined with the creation of vias by a thermomigration process.

17. Method according to claim 11, wherein at least part of the rear surface area inside the recesses, connected to the via, is diffused with the same polarity as the front surface doped layer.

18. Method according to claim 17, wherein the rear surface area inside the recesses is diffused with at least 10¹³ cm⁻² of dopant atoms.

19. Back-contacted solar cell manufactured by a method according to any one of the preceding claims 1 - 18; the solar cell comprising:
a silicon semiconductor substrate having a front and a rear surface;
- having on the rear surface a doped layer of the first conductivity type in the silicon semi substrate, as rear surface doped layer for functioning as back surface field layer in the solar cell;
- having on the front surface a doped layer of a second conductivity type as front surface doped layer for functioning as an emitter layer in the solar cell, the second conductivity type being opposite to the first conductivity type;
wherein:
the rear surface comprises recesses that pattern the back surface field layer of the first conductivity type in back surface field areas, the recesses being void of back surface field layer material
the substrate comprises via holes between the front and rear surfaces, the via holes being located within the recesses.

20. Back-contacted solar cell according to claim 19, wherein the solar comprises an anti reflection coating layer on the passivation layer on at least the front surface.

21. Back-contacted solar cell according to claim 19 or 20, where a depth of the recess is at least equal to or larger than the thickness of the rear surface doped layer.

22. Back-contacted solar cell according to any one of claims 19 - 21, further comprising:
a passivation layer on walls of the via holes, and
an anti-reflection coating layer covering the passivation layer on the walls of the via hole.

23. Back-contacted solar cell according to any one of claims 19 - 22, further comprising:
an emitter layer on walls of each via hole, and
the emitter layer on the walls of the via holes being covered by a passivation layer;
the passivation layer being covered by an anti reflection coating layer.

24. Back-contacted solar cell according to claim 22 or 23, further comprising:
an emitter layer on the rear side at the location of the recesses where the back surface field layer is removed, connected to the emitter layer on walls of each via hole.

25. Back-contacted solar cell according to any one of claims 19 - 24, wherein the back surface field areas are covered by a protection barrier layer and the recessed areas are not covered by the protection barrier layer.

## Patentansprüche

1. Verfahren zum Herstellen einer Solarzelle umfassend das Bereitstellen eines Siliziumhalbleitersubstrats eines ersten Leitfähigkeitstyps, wobei das Substrat eine Vorder- und eine Rückfläche aufweist, mit:
Ausbilden einer dotierten Schicht des ersten Leitfähigkeitstyps in dem Siliziumhalbleitersubstrat auf der Rückfläche als dotierte Rückflächenschicht zum Fungieren als Hinterflächenfeldschicht in der Solarzelle;
Ausbilden einer dotierten Schicht eines zweiten Leitfähigkeitstyps auf der Vorderfläche als dotierte Vorderflächenschicht zum Fungieren als eine Emitterschicht in der Solarzelle, wobei der zweite Leitfähigkeitstyp entgegengesetzt zum ersten Leitfähigkeitstyp ist;
wobei das Verfahren ferner aufweist:
Ausbilden von Ausnehmungen in der Rückfläche, indem die dotierte Rückflächenschicht in dem Siliziumhalbleitersubstrat am Ort der Ausnehmungen entfernt wird, um die dotierte Hinterflächenfeldschicht des ersten Leitfähigkeitstyps so auszugestalten, dass Hinterflächenfeldflächen ausgebildet werden, wobei die Ausnehmungen frei von dotiertem Rückflächenschichtmaterial sind und die Ausnehmungen eine Tiefe aufweisen, welche mindestens identisch oder größer als die Dicke der dotierten Rückflächenschicht ist, und
Ausbilden von Durchgangslöchern in dem Substrat, wobei jedes Durchgangsloch innerhalb einer assoziierten Ausnehmung angeordnet ist.

2. Verfahren nach Anspruch 1, bei dem die dotierte Rückflächenschicht durch ein Vordiffusionsverfahren ausgebildet wird.

3. Verfahren nach Anspruch 1, bei dem die dotierte Rückflächenschicht durch ein Vordiffusionsverfahren ausgebildet wird, und während des Ausbildens der dotierten Vorderflächenfläche ko-diffundiert wird, um die Hinterflächenfeldschicht auszubilden.

4. Verfahren nach Anspruch 1, bei dem das Ausbilden der Ausnehmungen durch ein Verfahren durchgeführt wird, welches aus einer Gruppe ausgesucht wird umfassend Laserablation, wasserstrahlgeführte Laserablation, chemische Laserablation, ausgesetzte Wasserstrahlabriebablation und Lithographie.

5. Verfahren nach einem der Ansprüche 1 bis 4, bei dem
die Ausnehmungen in der Rückfläche nach dem Ausbilden der dotierten Vorderflächenschicht auf der Vorderfläche und der dotierten Rückflächenschicht auf der Rückenfläche ausgebildet werden, und
die Durchgangslöcher in dem Substrat nach dem Ausbilden der dotierten Vorderflächenschicht auf der Vorderfläche und der dotierten Rückflächenschicht auf der Rückfläche ausgebildet werden.

6. Verfahren nach einem der Ansprüche 1 bis 4 mit dem Auftragen einer Antireflektionsbeschichtungsschicht auf mindestens der Vorderfläche, nachdem die dotierte Vorderflächenfläche auf der Vorderfläche ausgebildet wurde, wobei die Ausnehmungen in der Rückfläche nach dem Auftragen der Antireflektionsbeschichtungsschicht ausgebildet werden, und die Durchgangslöcher in dem Substrat nach dem Auftragen der Antireflektionsbeschichtungsschicht ausgebildet werden.

7. Verfahren nach einem der Ansprüche 1 bis 4, bei dem die Durchgangslöcher in dem Substrat vor dem Ausbilden der dotierten Rückflächenschicht ausgebildet werden, und
die Ausnehmungen in der Rückfläche nach dem Ausbilden der dotierten Vorderflächenschicht ausgebildet werden.

8. Verfahren nach einem der Ansprüche 1 bis 4, bei dem die Durchgangslöcher in dem Substrat vor dem Ausbilden der dotierten Rückflächenschicht ausgebildet werden, und
die Ausnehmungen in der Rückfläche vor dem Ausbilden der dotierten Vorderflächenschicht ausgebildet werden.

9. Verfahren nach einem der Ansprüche 1 bis 4, bei dem die Durchgangslöcher in dem Substrat nach dem Ausbilden der dotierten Rückflächenschicht aber vor dem Ausbilden der dotierten Vorderflächenschicht ausgebildet werden, und
die Ausnehmungen in der Rückfläche nach dem Ausbilden der dotierten Vorderflächenschicht ausgebildet werden.

10. Verfahren nach einem der Ansprüche 1 bis 4, bei dem die Ausnehmungen in der Rückfläche in der dotierten Rückflächenschicht vor dem Ausbilden der dotierten Vorderflächenschicht ausgebildet werden, und
die Durchgangslöcher in dem Substrat nach dem Ausbilden der dotierten Vorderflächenschicht ausgebildet werden.

11. Verfahren nach einem der Ansprüche 1 bis 4, bei dem die Ausnehmungen in der Rückfläche in der dotierten Rückflächenschicht vor dem Ausbilden der dotierten Vorderflächenschicht ausgebildet werden, und
die Durchgangslöcher in dem Substrat nach dem Ausbilden der dotierten Rückflächenschicht aber vor dem Ausbilden der dotierten Vorderflächenschicht ausgebildet werden.

12. Verfahren nach einem der Ansprüche 1 bis 6 oder einem der Ansprüche 9 bis 11, bei welchem dem Ausbilden der Durchgangslöcher das Auftragen einer Ätzschutzabdeckung auf der Rück- oder der Vorder- und Rückfläche vorangeht.

13. Verfahren nach einem der Ansprüche 1 bis 6 oder einem der Ansprüche 7 bis 11, bei welchem dem Ausbilden der Ausnehmungen das Auftragen einer Ätzschutzabdeckung auf der Rück- oder der Vorder- und Rückfläche vorangeht.

14. Verfahren nach Anspruch 5 oder 7 oder 12 oder 13, bei dem das Auftragen einer Ätzschutzabdeckung auf der Rückseite dem Ausbilden der dotierten Vorderseitenschicht vorangeht.

15. Verfahren nach Anspruch 5 oder 7 oder 12 oder 13, bei dem das Auftragen einer Ätzschutzabdeckung auf der Rückseite dem Ausbilden der dotierten Vorderseitenschicht folgt.

16. Verfahren nach Anspruch 1, bei dem das Ausbilden der Durchgangslöcher mit dem Ausbilden von Durchgängen durch einen Thermomigrationsprozess vereint wird.

17. Verfahren nach Anspruch 11, bei dem mindestens ein Teil der Rückflächenfläche innerhalb der Ausnehmungen, welcher mit dem Durchgang verbunden ist, mit derselben Polarität wie die dotierte Vorderflächenschicht diffundiert wird.

18. Verfahren nach Anspruch 17, bei dem die Rückflächenfläche innerhalb der Ausnehmungen mit mindestens 10¹³ cm⁻² von Dotieratomen diffundiert wird.

19. Rückkontaktierte Solarzelle, die mit einem Verfahren nach einem der vorhergehenden Ansprüche 1 bis 18 hergestellt wird, wobei die Solarzelle aufweist:
ein Siliziumhalbleitersubstrat mit einer Vorder- und einer Rückfläche, wobei auf der Rückfläche eine dotierte Schicht des ersten Leitfähigkeitstyps in dem Siliziumhalbleitersubstrat als dotierte Rückflächenschicht zum Fungieren als Hinterflächenfeldschicht in der Solarzelle ausgebildet ist, und
auf der Vorderfläche eine dotierte Schicht eines zweiten Leitfähigkeitstyps als dotierte Vorderflächenschicht zum Fungieren als eine Emitterschicht in der Solarzelle ausgebildet ist, wobei der zweite Leitfähigkeitstyp entgegengesetzt zu dem ersten Leitfähigkeitstyp ist;
wobei:
die Rückfläche Ausnehmungen aufweist, welche die Hinterflächenfeldschicht des ersten Leitfähigkeitstyps in Hinterflächenfeldflächen ausgestaltet, wobei die Ausnehmungen frei von Hinterflächenfeldschichtmaterial sind, und
das Substrat Durchgangslöcher zwischen der Vorder- und Rückfläche aufweist, wobei die Durchgangslöcher innerhalb der Ausnehmungen angeordnet sind.

20. Rückkontaktierte Solarzelle nach Anspruch 19, bei welcher die Solarzelle eine Antireflektionsbeschichtungsschicht auf der Passivierungsschicht auf zumindest der Vorderfläche aufweist.

21. Rückkontaktierte Solarzelle nach Anspruch 19 oder 20, bei welcher eine Tiefe der Ausnehmung zumindest identisch oder größer als die Dicke der dotierten Rückflächenschicht ist.

22. Rückkontaktierte Solarzelle nach einem der Ansprüche 19 bis 21 mit ferner:
einer Passivierungsschicht auf Wänden der Durchgangslöcher, und
einer Antireflektionsbeschichtungsschicht, welche die Passivierungsschicht auf den Wänden des Durchgangslochs bedeckt.

23. Rückkontaktierte Solarzelle nach einem der Ansprüche 19 bis 22 mit ferner:
einer Emitterschicht auf Wänden von jedem Durchgangsloch, wobei
die Emitterschicht auf den Wänden der Durchgangslöcher durch eine Passivierungsschicht bedeckt ist, und die Passivierungsschicht durch eine Antireflektionsbeschichtungsschicht bedeckt ist.

24. Rückkontaktierte Solarzelle nach Anspruch 22 oder 23 mit ferner:
einer Emitterschicht auf der Rückseite am Ort der Ausnehmungen, an dem die Hinterflächenfeldschicht entfernt ist, welche mit der Emitterschicht an Wänden von jedem Durchgangsloch verbunden ist.

25. Rückkontaktierte Solarzelle nach einem der Ansprüche 19 bis 24, bei welcher die Hinterflächenfeldflächen mit einer Schutzabdeckungsschicht bedeckt sind und die ausgenommenen Flächen nicht durch die Schutzabdeckungsschicht bedeckt sind.

## Revendications

1. Procédé de fabrication d'une cellule solaire comprenant le fait de fournir un substrat semi-conducteur en silicium d'un premier type de conductivité, le substrat ayant des surfaces antérieure et postérieure ;
le procédé comprenant le fait :
de créer sur la surface postérieure une couche dopée du premier type de conductivité dans le substrat semi-conducteur en silicium, en tant que couche dopée de surface postérieure pour fonctionner comme une couche de champ de surface arrière dans la cellule solaire ;
de créer sur la surface antérieure une couche dopée d'un deuxième type de conductivité en tant que couche dopée de surface antérieure pour fonctionner comme une couche d'émetteur dans la cellule solaire, le deuxième type de conductivité étant opposé au premier type de conductivité ;
dans lequel le procédé comprend en outre le fait :
de créer des évidements dans la surface postérieure par retrait de la couche dopée de surface postérieure dans le substrat semi-conducteur en silicium au niveau de l'emplacement des évidements pour former des motifs sur la couche de champ dopée de surface postérieure du premier type de conductivité de manière à créer des zones de champ de surface arrière, les évidements étant dépourvus de matériau de couche dopée de surface postérieure et les évidements ayant une profondeur au moins supérieure ou égale à l'épaisseur de la couche dopée de surface postérieure ; et
de créer des trous de liaison dans le substrat, chaque trou de liaison étant positionné à l'intérieur d'un évidement qui lui est associé.

2. Procédé selon la revendication 1, dans lequel la couche dopée de surface postérieure est créée par un processus de pré-diffusion.

3. Procédé selon la revendication 1, dans lequel la couche dopée de surface postérieure est créée par un processus de pré-diffusion, et pendant la formation de la zone dopée de surface antérieure est co-diffusée pour former la couche de champ de surface arrière.

4. Procédé selon la revendication 1, dans lequel la création des évidements est faite par un processus choisi dans un groupe comprenant l'ablation par laser, l'ablation par laser guidé avec un jet d'eau, l'ablation chimique par laser, l'ablation par jet d'eau avec abrasif en suspension et la lithographie.

5. Procédé selon l'une quelconque des revendications 1 à 4, dans lequel les évidements dans la surface postérieure sont créés après la création de la couche dopée de surface antérieure sur la surface antérieure et de la couche dopée de surface postérieure sur la surface postérieure, et
les trous de liaison dans le substrat sont créés après la création de la couche dopée de surface antérieure sur la surface antérieure et de la couche dopée de surface postérieure sur la surface postérieure.

6. Procédé selon l'une quelconque des revendications 1 à 4, comprenant le fait de déposer une couche de revêtement antireflet sur au moins la surface antérieure après la création de la zone dopée de surface antérieure sur la surface antérieure, où les évidements dans la surface postérieure sont créés après le dépôt de la couche de revêtement antireflet, et les trous de liaison dans le substrat sont créés après le dépôt de la couche de revêtement antireflet.

7. Procédé selon l'une quelconque des revendications 1 à 4, dans lequel les trous de liaison dans le substrat sont créés avant la création de la couche dopée de surface postérieure, et
les évidements dans la surface postérieure sont créés après la création de la couche dopée de surface antérieure.

8. Procédé selon l'une quelconque des revendications 1 à 4, dans lequel les trous de liaison dans le substrat sont créés avant la création de la couche dopée de surface postérieure, et
les évidements dans la surface postérieure sont créés avant la création de la couche dopée de surface antérieure.

9. Procédé selon l'une quelconque des revendications 1 à 4, dans lequel les trous de liaison dans le substrat sont créés après la création de la couche dopée de surface postérieure mais avant la création de la couche dopée de surface antérieure, et
les évidements dans la surface postérieure sont créés après la création de la couche dopée de surface antérieure.

10. Procédé selon l'une quelconque des revendications 1 à 4, dans lequel les évidements dans la surface postérieure sont créés dans la couche dopée de surface postérieure mais avant la création de la couche dopée de surface antérieure, et
les trous de liaison dans le substrat sont créés après la création de la couche dopée de surface antérieure.

11. Procédé selon l'une quelconque des revendications 1 à 4, dans lequel les évidements dans la surface postérieure sont créés dans la couche dopée de surface postérieure mais avant la création de la couche dopée de surface antérieure, et
les trous de liaison dans le substrat sont créés après la création de la couche dopée de surface postérieure mais avant la création de la couche dopée de surface antérieure.

12. Procédé selon l'une quelconque des revendications précédentes 1 à 6 ou l'une quelconque des revendications 9 à 11, dans lequel la création des trous de liaison est précédée par le dépôt d'une barrière de protection contre la gravure soit sur la surface postérieure ou sur les surfaces antérieure et postérieure.

13. Procédé selon l'une quelconque des revendications précédentes 1 à 6 ou l'une quelconque des revendications 7 à 11, dans lequel la création des évidements est précédée par le dépôt d'une barrière de protection contre la gravure soit sur la surface postérieure ou sur les surfaces antérieure et postérieure.

14. Procédé selon la revendication 5 ou 7 ou 12 ou 13, dans lequel le dépôt d'une barrière de protection contre la gravure sur le côté postérieur précède la création de la couche dopée de côté antérieur.

15. Procédé selon la revendication 5 ou 7 ou 12 ou 13, dans lequel le dépôt d'une barrière de protection contre la gravure sur le côté postérieur suit la création de la couche dopée de côté antérieur.

16. Procédé selon la revendication 1, dans lequel la création des trous de liaison est combinée avec la création de trous d'interconnexion par un processus de thermo-migration.

17. Procédé selon la revendication 11, dans lequel au moins une partie de la zone de surface postérieure à l'intérieur des évidements, reliée au trou d'interconnexion, est diffusée avec la même polarité que la couche dopée de surface antérieure.

18. Procédé selon la revendication 17, dans lequel la zone de surface postérieure à l'intérieur des évidements est diffusée avec au moins 10¹³ cm⁻² d'atomes de dopant.

19. Cellule solaire à contact arrière fabriquée par un procédé selon l'une quelconque des revendications précédentes 1 à 18 ; la cellule solaire comprenant :
un substrat semi-conducteur en silicium ayant des surfaces antérieure et postérieure ;
ayant sur la surface postérieure une couche dopée du premier type de conductivité dans le substrat semi-conducteur en silicium, en tant que couche dopée de surface postérieure pour fonctionner comme une couche de champ de surface arrière dans la cellule solaire ;
ayant sur la surface antérieure une couche dopée d'un deuxième type de conductivité en tant que couche dopée de surface antérieure pour fonctionner comme une couche d'émetteur dans la cellule solaire, le deuxième type de conductivité étant opposé au premier type de conductivité ;
dans laquelle la surface postérieure comprend des évidements qui forment des motifs sur la couche de champ de surface arrière du premier type de conductivité dans des zones de champ de surface arrière, les évidements étant dépourvus de matériau de couche de champ de surface arrière ;
le substrat comprend des trous de liaison entre les surfaces antérieure et postérieure, les trous de liaison étant situés à l'intérieur des évidements.

20. Cellule solaire à contact arrière selon la revendication 19, dans laquelle la cellule solaire comprend une couche de revêtement antireflet sur la couche de passivation sur au moins la surface antérieure.

21. Cellule solaire à contact arrière selon la revendication 19 ou 20, dans laquelle une profondeur de l'évidement est au moins supérieure ou égale à l'épaisseur de la couche dopée de surface postérieure.

22. Cellule solaire à contact arrière selon l'une quelconque des revendications 19 à 21, comprenant en outre :
une couche de passivation sur les parois des trous de liaison, et
une couche de revêtement antireflet recouvrant la couche de passivation sur les parois du trou de liaison.

23. Cellule solaire à contact arrière selon l'une quelconque des revendications 19 à 22, comprenant en outre :
une couche d'émetteur sur les parois de chaque trou de liaison, et
la couche d'émetteur sur les parois des trous de liaison étant recouverte par une couche de passivation ;
la couche de passivation étant recouverte par une couche de revêtement antireflet.

24. Cellule solaire à contact arrière selon la revendication 22 ou 23, comprenant en outre :
une couche d'émetteur sur le côté postérieur au niveau de l'emplacement des évidements où la couche de champ de surface arrière est retirée, reliée à la couche d'émetteur sur les parois de chaque trou de liaison.

25. Cellule solaire à contact arrière selon l'une quelconque des revendications 19 à 24, dans laquelle les zones de champ de surface arrière sont recouvertes par une couche barrière de protection et les zones évidées ne sont pas recouvertes par la couche barrière de protection.
